(19) Europäisches Patentamt
European Patent Office
Office européen des brevets

(11) **EP 3 944 272 B1**

(12) **EUROPEAN PATENT SPECIFICATION**

(45) Date of publication and mention
of the grant of the patent:
**16.10.2024 Bulletin 2024/42**

(21) Application number: **20773871.7**

(22) Date of filing: **17.03.2020**

(51) International Patent Classification (IPC):
**H01F 41/04** (2006.01)   **H01F 1/26** (2006.01)
**H01F 41/16** (2006.01)   **H05K 1/16** (2006.01)
*H01F 1/37* (2006.01)   *H01F 17/00* (2006.01)
*H01F 27/29* (2006.01)   *H05K 3/42* (2006.01)

(52) Cooperative Patent Classification (CPC):
**H01F 41/046; H01F 1/26; H01F 41/16; H05K 1/165;**
H01F 1/37; H01F 17/0013; H01F 27/292;
H05K 3/427; H05K 2201/086

(86) International application number:
**PCT/JP2020/011829**

(87) International publication number:
**WO 2020/189692 (24.09.2020 Gazette 2020/39)**

(54) **CIRCUIT BOARD MANUFACTURING METHOD**

LEITERPLATTENHERSTELLUNGSVERFAHREN

PROCÉDÉ DE FABRICATION DE CARTE DE CIRCUIT IMPRIMÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.03.2019 JP 2019050281**

(43) Date of publication of application:
**26.01.2022 Bulletin 2022/04**

(73) Proprietor: **AJINOMOTO CO., INC.**
**Chuo-ku**
**Tokyo 104-8315 (JP)**

(72) Inventors:
• **OOYAMA, Hideki**
**Kawasaki-shi, Kanagawa 210-0801 (JP)**

• **TANAKA, Takayuki**
**Kawasaki-shi, Kanagawa 210-0801 (JP)**
• **MATSUMURA, Eri**
**Kawasaki-shi, Kanagawa 210-0801 (JP)**

(74) Representative: **Mewburn Ellis LLP**
**Aurora Building**
**Counterslip**
**Bristol BS1 6BX (GB)**

(56) References cited:
**EP-A1- 3 771 303**      **JP-A- 2001 203 463**
**JP-A- 2001 203 463**    **JP-A- 2005 317 351**
**JP-A- 2012 131 899**    **JP-A- 2017 174 949**
**JP-A- 2019 001 849**    **KR-B1- 101 564 197**
**US-A1- 2002 033 275**

**Description**

Field

The present invention relates to a method for producing a circuit substrate using a resin composition containing a magnetic powder and to the said composition. Background

An inductor, which is also called a power inductor, a high frequency inductor, or a common mode choke coil, is frequently equipped to an information terminal of a mobile phone, a smart phone, and the like. Conventionally, an independent inductor part has been mounted on a circuit substrate; but, in recent years, the method is being used in which a coil is formed by a conductive pattern of a circuit substrate thereby forming the inductor inside the circuit substrate.

For example, Patent Document 1 discloses a multilayered circuit substrate having a built-in inductor, in which a spiral conductive pattern is formed by spirally winding a plurality of layers of a multilayered substrate more than once, then the upper layer and the lower layer of the respective layer's conductive pattern ends are connected to each other thereby forming a spiral coil as a whole. In order to reduce the thickness of the circuit substrate, Patent Document 2 discloses the inductor part that is included in a core substrate of the circuit substrate.

In the case when the inductor part having an inductor that is formed by a plurality of the conductive patterns formed on an insulating layer is produced, it may be presumed to use a resin composition containing a magnetic powder as the material to form the insulating layer. When the insulating layer containing the magnetic powder (magnetic cured product layer) is used, not only the inductance value can be increased, but also leakage of the magnetic field line to outside the inductor can be avoided. For example, Patent Document 2 discloses that the resin composition that constitutes the resin composition layer in a resin sheet attached with a support is made to include the magnetic powder thereby making the insulating layer thus formed the magnetic body.

Furthermore, for example, Patent Document 3 discloses the inductor part that achieves smallness and a high inductance, in which a through hole in the circuit substrate for an inductor part is filled with the resin composition containing a magnetic powder to form a magnetic core, and this magnetic core is disposed in the center of the coil formed with a wiring layer of the circuit substrate.

US 2002/033275 discloses a method for filling through-holes in circuit boards based on a thermally cured composition of epoxy, hardener, and magnetic particles, the latter may include Ni.

Citation List

Patent Document

    Patent Document 1: Japanese Patent Application Laid-open No. 2009-16504
    Patent Document 2: Japanese Patent Application Laid-open No. 2012-186440
    Patent Document 3: Japanese Patent Application Laid-open No. 2016-197624

Summary

Technical Problem

In production of these inductor parts (circuit substrates), there is the case that the conductive layer is formed on the magnetic cured product layer containing the magnetic powder; it is desired to form the conductive layer with wet plating that is advantageous in the cost.

When the conductive layer is formed on the insulating layer not containing the magnetic powder, it is general to form the conductive layer after the surface of the insulating layer is treated with an oxidizing agent. However, in the case when the conductive layer is formed on the magnetic cured product layer containing the magnetic powder, the inventors of the present invention had already found that when the surface of the magnetic cured product layer is treated with the oxidizing agent, the resin and the magnetic powder are eluted thereby causing the magnetic cured product layer brittle so that it is difficult to have good plating adhesion.

Accordingly, the inventors of the present invention studied the method in which the conductive layer is formed by polishing the surface of the magnetic cured product layer as the process to form the conductive layer on the magnetic cured product layer without using the oxidizing agent. However, when the conductive layer is formed on the magnetic cured product layer by the wet plating after polishing of the surface of the magnetic cured product layer, the inventors found at the wet plating process the new problem of fouling in the bath, the substrate, and the like, caused by formation of magnetic foreign matters such as precipitates and deposits presumably originated from the magnetic powder included in the magnetic cured product layer. In particular, when conducting electroless plating, it was found that the fouling is eminent at the catalyst activating process to activate a catalyst by a reducing agent after the catalyst such as palladium is attached to the surface of the magnetic cured product layer.

The present invention was attempted in view of the circumstances mentioned above, and thus has an object to provide the production method of the base substrate that is suppressed in formation of the magnetic foreign matters in production of the circuit substrate having the conductive layer formed by the wet plating on the magnetic cured product layer containing the magnetic powder even without treating the surface of the magnetic cured product layer by an oxidizing agent.

Solution to Problem

The inventors of the present invention carried out an extensive investigation to achieve the object mentioned above; as a result, it was found that when the magnetic powder containing nickel is used in the resin composition, generation of the magnetic foreign matters can be suppressed at the wet plating process even when polishing is carried out in place of treating the surface of the magnetic cured product layer by an oxidizing agent.

Namely, the present invention includes following contents.

[1] A method for producing a circuit substrate, the method comprising:

(1) a step at which a resin composition is thermally cured to obtain a magnetic cured product,
(2) a step at which at least part of a surface of the magnetic cured product is polished, and
(3) a step at which a conductive layer is formed by wet plating on at least part of the surface of the magnetic cured product thus polished, the steps being included in this order,

the resin composition comprising:

(A) a magnetic powder containing nickel,
(B) an epoxy resin, and
(C) a curing agent.

[2] The method for producing a circuit substrate further requires that the component (A) is a nickel iron alloy type metal powder or a nickel-containing iron oxide powder.

[3] The method for producing a circuit substrate further requires that a nickel content in the component (A) is in a range of 30 to 90% by mass.

[4] The method for producing a circuit substrate according to any of the above [1] to [3], wherein a content of the component (A) in the resin composition is in a range of 70 to 98% by mass based on 100% by mass of nonvolatile components in the resin composition.

[5] The method for producing a circuit substrate according to any of the above [1] to [4], wherein a weight retention rate of the component (A) upon being soaked in 2 N sulfuric acid at 40°C for 5 minute is 90% or more.

[6] The method for producing a circuit substrate according to any of the above [1] to [5], wherein the component (B) comprises an epoxy resin that is liquid at 25°C.

[7] The method for producing a circuit substrate according to any of the above [1] to [6], wherein the component (C) is a curing agent selected from the group consisting of an acid anhydride type curing agent, an amine type curing agent, and an imidazole type curing agent.

[8] The method for producing a circuit substrate according to any of the above [1] to [7], wherein a pencil hardness of the surface of the magnetic cured product obtained at the step (1) measured in accordance with JIS K 5600-5-4 is in a range of F to 5H.

[9] The method for producing a circuit substrate according to any of the above [1] to [8], wherein an etching rate when the magnetic cured product obtained at the step (1) is soaked in a soft etching liquid ($Na_2S_2O_8$ 100 g/L, $H_2SO_4$ (75% aqueous solution)) at 30°C for 1 minute is 25 mg/cm$^2$ or less.

[10] The method for producing a circuit substrate according to any of the above [1] to [9], wherein the resin composition is in a paste-like form.

Advantageous Effects of Invention

When the magnetic cured product obtained by curing the resin composition according to the present invention is used in production of the circuit substrate, the amount of the magnetic foreign matters that are producible in the treatment liquid at the wet plating process can be suppressed even when the surface of the magnetic cured product layer is not treated with an oxidizing agent.

Brief Description of Drawings

FIG. 1 is a schematic sectional view of the core substrate, as one example of the first embodiment with regard to the production method of the circuit substrate.

FIG. 2 is a schematic sectional view of the core substrate formed with a through hole, as one example of the first embodiment with regard to the production method of the circuit substrate.

FIG. 3 is a schematic sectional view illustrating the state of the plated layer formed in the through hole, as one example of the first embodiment with regard to the production method of the circuit substrate.

FIG. 4 is a schematic sectional view illustrating the state of the through hole that is filled with the paste for filling the through hole, as one example of the first embodiment with regard to the production method of the circuit substrate.

FIG. 5 is a schematic sectional view illustrating the state of the magnetic cured product formed by thermally curing the paste for filling the through hole that is filled therein, as one example of the first embodiment with regard to the production method of the circuit substrate.

FIG. 6 is a schematic sectional view illustrating the state of the magnetic cured product after having been polished, as one example of the first embodiment with regard to the production method of the circuit substrate.

FIG. 7 is a schematic sectional view illustrating the state of the conductive layer formed on the polished surface, as one example of the first embodiment with regard to the production method of the circuit substrate.

FIG. 8 is a schematic sectional view illustrating the state of the formed patterned conductive layer, as one example of the first embodiment with regard to the production method of the circuit substrate.

FIG. 9 is a schematic sectional view to explain the step ($\alpha$), as one example of the second embodiment with regard to the production method of the circuit substrate.

FIG. 10 is a schematic sectional view to explain the step ($\alpha$), as one example of the second embodiment with regard to the production method of the circuit substrate.

FIG. 11 is a schematic sectional view to explain the step ($\beta$), as one example of the second embodiment with regard to the production method of the circuit substrate.

FIG. 12 is a schematic sectional view illustrating the state of the formed patterned conductive layer, as one example of the second embodiment with regard to the production method of the circuit substrate.

FIG. 13 is a schematic plane view observed from one side in the thickness direction of the inductor part that includes the circuit substrate obtained by the production method of the circuit substrate according to the second embodiment as one example.

FIG. 14 is a schematic view illustrating a cut edge face of the inductor part including the circuit substrate obtained by the production method of the circuit substrate according to the second embodiment; the inductor part being cut at the place indicated by the II-II one dot chain line as one example.

FIG. 15 is a schematic plane view to explain the composition of the first conductive layer in the inductor part that includes the circuit substrate obtained by the production method of the circuit substrate according to the second embodiment as one example.

Description of Embodiments

Hereinafter, with referring to the drawings, embodiments of the present invention will be explained. In these drawings, the shape, size, and arrangement of the composition elements are roughly illustrated so as to merely help to understand the present invention. The present invention is not limited by the embodiments described below; and thus, each of the composition elements may be changed as appropriate. In the following drawings to be used for explanation, the same composition elements are tagged with the same symbols and there are cases that the overlapped explanation thereof is omitted. In addition, the compositions relating to the embodiments of the present invention are not necessarily produced or used in accordance with the arrangements illustrated in the drawings.

Circuit Substrate

The circuit substrate means the substrate having a conductive layer (circuit) formed on one or both surfaces thereof. The circuit substrate may be used as the wiring board to mount an electronic part such as a semiconductor chip, and may also be used as a (multilayered) printed wiring board that uses this wiring board as an inner layer substrate.

Hereinafter, the production method of the circuit substrate will be explained.

Production Method of Circuit Substrate

The production method of the circuit substrate according to the present invention includes: (1) a step at which a resin composition is thermally cured to obtain a magnetic cured product; (2) a step at which at least part of a surface of the magnetic cured product is polished; and (3) a step at which a conductive layer is formed by wet plating on at least part of the surface of the magnetic cured product thus polished, these steps being included in this order. In addition, the resin composition includes (A) a magnetic powder containing nickel, (B) an epoxy resin, and (C) a curing agent. The resin composition of the present invention uses, as the magnetic powder, (A) the magnetic powder containing nickel that is resistant to an acid. Therefore, when the magnetic cured product thereof is used in the production of the circuit substrate, generation of the magnetic foreign matters producible in the treatment liquid at the wet plating process can be suppressed significantly even when polishing is carried out in place of treating the surface of the magnetic cured product layer by an oxidizing agent; thus, fouling of the bath, the substrate, and the like can be avoided. In particular, the circuit substrate provided with the magnetic cured product having the surface that includes (A) the magnetic powder containing nickel and with the conductive layer formed on the said surface can be produced with suppressing generation of the magnetic foreign matters. In addition, in one embodiment, the resin composition of the present invention includes the component (A), so that the magnetic cured product having the hardness suitable for polishing can be readily obtained. Accordingly, because the magnetic cured product of the resin composition in the present embodiment according to the present invention has a superior polishing property, the polishing at the polishing step (2) in the wet plating process can be conducted efficiently.

Step (1)

At the step (1), the resin composition is thermally cured to obtain the magnetic cured product. The form of the magnetic cured product is not particularly restricted, and thus, this can be configured as appropriate in accordance with the use embodiment thereof and the like. The step (1) may include the step to prepare the resin composition. The curing temperature of the resin composition at the step (1) is preferably 120°C or higher, and more preferably 130°C or higher, while still more preferably 150°C or higher, and preferably 240°C or lower, and more preferably 220°C or lower, while still more preferably 200°C or lower, although these values are different depending on the composition and kind of the resin composition. The curing period of the resin composition is preferably 5 minutes or longer, more and preferably 10 minutes or longer, while still more preferably 15 minutes or longer, and preferably 120 minutes or shorter, and more preferably 100 minutes or shorter, while still more preferably 90 minutes or shorter.

Before thermally curing the resin composition, the resin composition may be preliminarily heated at the temperature lower than the curing temperature thereof. For example, before thermally curing the resin composition, the resin composition may be pre-heated usually at 50°C or higher and lower than 120°C (preferably in the range of 60°C to 110°C both inclusive, while more preferably in the range of 70°C to 100°C both inclusive) with the period of usually 5 minutes or longer (preferably in the range of 5 to 150 minutes, while more preferably in the range of 15 to 120 minutes).

The curing degree of the magnetic cured product that is obtained at the step (1) is preferably 80% or more, and more preferably 85% or more, while still more preferably 90% or more. The curing degree may be measured by using, for example, a differential scanning calorimeter.

Step (2)

The step (2) is a step at which the surface of the magnetic cured product is polished. The polishing may be done at least part of the surface of the magnetic cured product. Illustrative examples of the polishing method include a buff polishing method and a belt polishing method. Illustrative examples of the buff polishing equipment that is commercially available include "NT-700IM" manufactured by Ishiihyoki Co., Ltd.

From a viewpoint to enhance the plating adhesion with the conductive layer, the arithmetic average roughness (Ra) of the polished surface of the magnetic cured product is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) may be measured by using, for example, a non-contact type surface roughness meter.

After the step (2) and before the step (3), in order to further enhance the curing degree of the magnetic cured product and the like, a heat-treatment step may be carried out as needed. The temperature at the heat-treatment step may be chosen with referring to the curing temperature described before; thus, the temperature is preferably 120°C or higher, and more preferably 130°C or higher, while still more preferably 150°C or higher, and preferably 240°C or lower, and more preferably 220°C or lower, while still more preferably 200°C or lower. The heat-treatment period is preferably 5 minutes or longer, and more preferably 10 minutes or longer, while still more preferably 15 minutes or longer, and preferably 90 minutes or shorter, and more preferably 70 minutes or shorter, while still more preferably 60 minutes or shorter.

Because the surface of the magnetic cured product is polished at the step (2), the conductive layer can be formed on the magnetic cured product without treating the surface by an oxidizing agent. Therefore, the magnetic cured product can be prevented from becoming brittle; and the plating adhesion can be enhanced.

On the polished surface of the magnetic cured product thus obtained, part of (A) the magnetic powder containing nickel may be exposed; but, because the component (A) is resistant to an acid, generation of the foreign matters can be suppressed significantly.

Step (3)

The step (3) is a step at which the conductive layer is formed on at least part of the polished surface of the magnetic cured product by wet plating. (A) The magnetic powder containing nickel may be present in the polished surface of the magnetic cured product, but generation of the magnetic foreign matters can be suppressed because (A) the magnetic powder containing nickel is sluggish to elute into the liquid that is used in the plating. Illustrative examples of the material of the conductive layer include: single metals such as gold, platinum, palladium, silver, copper, aluminum, cobalt, chromium, zinc, nickel, titanium, tungsten, iron, tin, and indium; and alloys of two or more metals selected from the group consisting of gold, platinum, palladium, silver, copper, aluminum, cobalt, chromium, zinc, nickel, titanium, tungsten, iron, tin, and indium. Among these, in view of versatility, cost, patterning easiness, and the like, preferable are chromium, nickel, titanium, aluminum, zinc, gold, palladium, silver, copper, a nickel chromium alloy, a copper nickel alloy, and a copper titanium alloy. More preferable are chromium, nickel, titanium, aluminum, zinc, gold, palladium, silver, copper, and a nickel chromium alloy; copper is still more preferable.

In the preferred embodiment of the step (3), it is preferable to form the conductive layer by an electroless plating treatment as the wet plating process, and it is more preferable to form the conductive layer by further conducting an electroplating treatment after the electroless plating treatment. Therefore, at the step (3), it is preferable that the conductive layer be formed by plating the surface of the magnetic cured product with a semi-additive method, a full additive method, or the like. In view of readiness in production of the conductive layer it is preferable that the conductive layer is formed by a semi-additive method at the step (3).

Details of the semi-additive method are as follows. First, a plated seed layer is formed on the surface of the magnetic cured product by the electroless plating treatment. Next, onto the plated seed layer thus formed is formed a mask pattern that part of the plated seed layer is exposed in accordance with an intended wiring pattern. After the conductive layer is formed by the electroplating treatment on the exposed plated seed layer, the mask pattern is removed. Then, an unnecessary plated seed layer is removed by etching or the like, and the conductive layer having the intended wiring pattern can be formed.

The electroless plating treatment is carried out by soaking the magnetic cured product into an electroless plating liquid. Illustrative examples the electroless plating treatment include an electroless copper plating, an electroless nickel plating, an electroless nickel-tungsten plating, an electroless tin plating, and an electroless gold plating; among these, the electroless copper plating is preferable.

Illustrative examples of the electroless plating liquid that is used in the electroless plating treatment include the liquid containing a metal ion such as copper, nickel, tungsten, tin, gold, palladium, and $PdCl_2$. The electroless plating liquid may include other additives such as a reducing agent. Commercially available products may be used as the electroless plating liquid. Illustrative examples of the commercially available product include "Thru-cup PEA" manufactured by C. Uyemura & Co., Ltd. and "S-KPD" manufactured by Japan Kanigen Co., Ltd.

From a viewpoint to activate the catalyst, the treatment period of the electroless plating treatment is preferably 10 minutes or longer, and more preferably 20 minutes or longer, while still more preferably 30 minutes or longer, and preferably 60 minutes or shorter, and more preferably 50 minutes or shorter, while still more preferably 40 minutes or shorter.

From a viewpoint to enhance the efficiency in formation of the conductive layer, the temperature of the electroless plating treatment is preferably 10°C or higher, and more preferably 20°C or higher, while still more preferably 30°C or higher, and preferably 60°C or lower, and more preferably 55°C or lower, while still more preferably 50°C or lower.

After the plated seed layer is formed by the electroless plating treatment, a dry film is laminated on the plated seed layer. Then, a mask pattern is formed by light-exposure and development under prescribed conditions by using a photomask in such a way as to expose part of the plated seed layer in accordance with an intended wiring pattern. Heretofore known conditions may be used as the light-exposure and development conditions.

A photosensitive dry film formed of a photoresist composition may be used as the dry film. Illustrative examples of the dry film like this include a novolak resin and an acrylic resin.

The mask pattern is used as a plating mask in the electrolytic copper plating treatment. The mask pattern is removed after the electroplating treatment.

The electroplating treatment is carried out by soaking the magnetic cured product after the electroless plating treatment in a plating liquid. The electroplating treatment is carried out by flowing an electric current in the plating bath. Illustrative examples of the electroplating treatment include an electrolytic copper plating, an electrolytic nickel plating, an electrolytic tin plating, and an electrolytic gold plating; among these, an electrolytic copper plating is preferable.

Illustrative examples of the plating bath that is used in the electroplating treatment include the bath containing copper sulfate, copper pyrophosphate, and copper cyanide.

From a viewpoint to activate the catalyst, the treatment period of the electroplating treatment is preferably 30 minutes or longer, more preferably 40 minutes or longer, while still more preferably 50 minutes or longer, and preferably 90 minutes or shorter, more preferably 80 minutes or shorter, while still more preferably 70 minutes or shorter.

From a viewpoint to enhance the efficiency in formation of the conductive layer, the temperature of the electroplating treatment is preferably 10°C or higher, more preferably 15°C or higher, while still more preferably 20°C or higher, and preferably 50°C or lower, more preferably 40°C or lower, while still more preferably 30°C or lower.

From a viewpoint to enhance the efficiency in formation of the conductive layer, the current density at the electroplating treatment is preferably 1.0 A/dm$^2$ or more, more preferably 1.5 A/dm$^2$ or more, while still more preferably 2.0 A/dm$^2$ or more, and preferably 4.0 A/dm$^2$ or less, more preferably 3.5 A/dm$^2$ or less, while still more preferably 3.0 A/dm$^2$ or less.

In order to enhance the peel strength of the conductive layer and the like, after the conductive layer is formed, an annealing treatment may be carried out, as needed. The annealing treatment may be carried out, for example, by heating the substrate in the temperature range of 150 to 200°C for the period of 20 to 90 minutes.

From a viewpoint of thinning, the thickness of the conductive layer is preferably 70 um or less, more preferably 60 um or less, still more preferably 50 um or less, far still more preferably 40 um or less, while especially preferably 30 um or less, 20 um or less, 15 um or less, or 10 um or less. The lower limit thereof is preferably 1 um or more, more preferably 3 um or more, while still more preferably 5 um or more.

Hereinafter, the first embodiment and the second embodiment will be explained as more specific examples of the production method of the circuit substrate. As a matter of course, the production method of the circuit substrate relating to the present invention is not limited to the first and second embodiments as exemplified below.

First Embodiment

The circuit substrate according to the first embodiment includes a substrate formed with a through hole and a magnetic cured product that fills the through hole. Accordingly, the production method of the circuit substrate according to the first embodiment includes:

(1A) a step at which a resin composition is filled in the through hole of the substrate, and then, the resin composition is thermally cured to form a magnetic cured product,
(2A) a step at which at least part of a surface of the magnetic cured product is polished, and
(3A) a step at which a conductive layer is formed by wet plating on at least part of the surface of the magnetic cured product thus polished, these steps being included in this order.

Preferably, after the step (2A) and before the step (3A), the production method of the circuit substrate according to the first embodiment further includes:

(2A-1) a conditioning step at which the surface of the magnetic cured product is treated with a solution containing a surfactant, and
(2A-2) a catalyzing step at which a catalyst is attached to the surface of the magnetic cured product, these steps being included in this order, and more preferably, after the step (2A-2) and before the step (3A), the production method further includes
(2A-3) a catalyst-activating step at which the catalyst is activated. When the steps (2A-1) to (2A-3) are carried out after completion of the step (2A), insoluble matters and the like that are generated especially at the step (2A-2) and the step (2A-3) can be suppressed.

In addition, after the step (2A-1) and before the step (2A-2), the production method may include
(2A-1-1) a micro-etching step at which the surfactant is removed from the portion where the surfactant is unnecessary.

Step (1A)

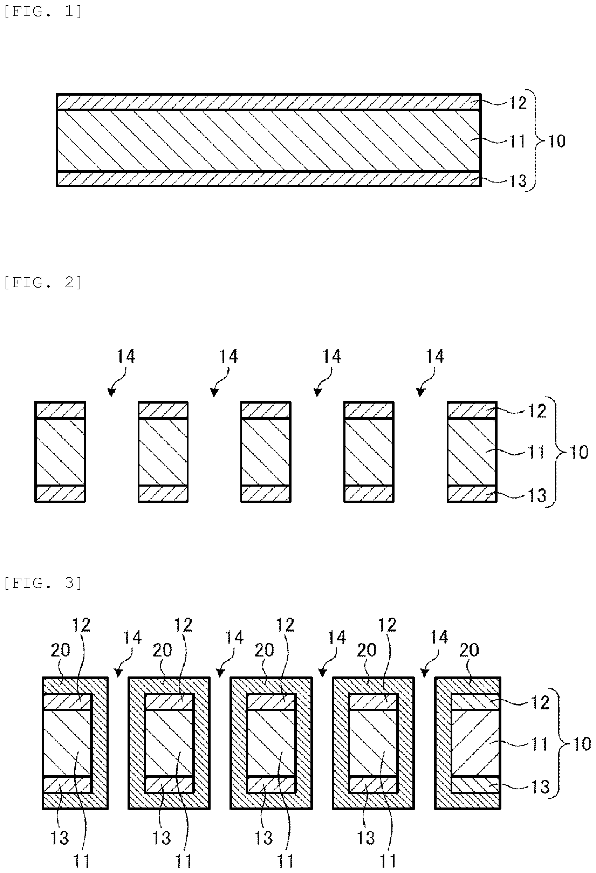

The step (1A) is a step at which a resin composition is filled in the through hole of the substrate, and then, the resin composition is thermally cured to form a magnetic cured product. At the step (1A), it is preferable that the magnetic cured product be formed by using a magnetic paste. Upon carrying out the step (1A), as illustrated in FIG. 1 as one example, this step may include a step to prepare a core substrate 10 having a supporting substrate 11, as well as a first metal layer 12 and a second metal layer 13, each of which is formed of a metal such as copper foil and arranged on each surface of the supporting substrate 11. Illustrative examples of the material of the supporting substrate 11 include insulating substrates such as a glass epoxy substrate, a metal substrate, a polyester substrate, a polyimide substrate, a BT resin substrate, and a thermosetting type polyphenylene ether substrate.

In addition, as illustrated in FIG. 2 as one example, this step may include a step to form a through hole 14 in the core substrate 10. The through hole 14 may be formed, for example, by drilling, laser irradiation, or plasma irradiation. Specifically, the through hole 14 may be formed by forming a penetrating hole through the core substrate 10 with a drill or the like.

Formation of the through hole 14 may be carried out by using a drilling machine that is commercially available. Illustrative examples of the commercially available drilling machine include "ND-1S211" manufactured by Hitachi Via Mechanics, Ltd.

After the through hole 14 is formed in the core substrate 10, as illustrated in FIG. 3 as one example, this step may include a step to carry out a roughening treatment to the core substrate 10 followed by formation of a plated layer 20 in the through hole 14, on the surface of the first metal layer 12, and on the surface of the second metal layer 13.

The roughening treatment may be carried out with any of a dry roughening treatment and a wet roughening treatment. Illustrative examples of the dry roughening treatment include a plasma treatment. Illustrative examples of the wet roughening treatment include a method in which a swelling treatment by a swelling liquid, a roughening treatment by an oxidant, and a neutralizing treatment by a neutralizing solution are carried out in this order.

The plated layer 20 is formed by a plating method. The procedure to form the plated layer 20 by the plating method is the same as that in formation of the conductive layer at the step (3A) to be described later.

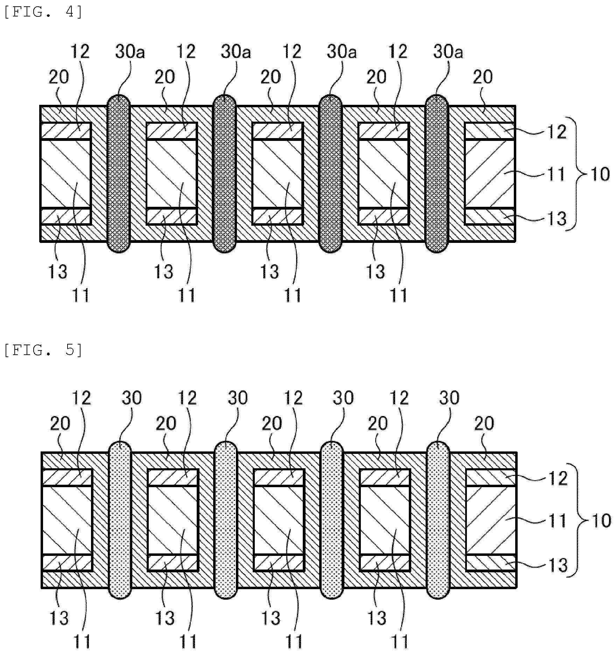

After the core substrate 10 having the plated layer 20 formed in the through hole 14 is prepared, as illustrated in FIG. 4 as one example, a resin composition 30a is filled into the through hole 14. Illustrative examples of the filling method include a method in which the resin composition 30a is filled in the through hole 14 via a squeegee, a method in which the resin composition 30a is filled via a cartridge, a method in which the resin composition 30a is filled by a mask printing, a roll coating method, and an inkjet method. The resin composition 30a is preferably a magnetic paste.

After the resin composition 30a is filled into the through hole 14, the resin composition 30a is thermally cured to form a magnetic cured product 30 in the through hole 14, as illustrated in FIG. 5 as one example. The thermal curing condition of the resin composition 30a at the step (1A) and the curing degree of the magnetic cured product 30 are the same as those described at the step (1).

Step (2A)

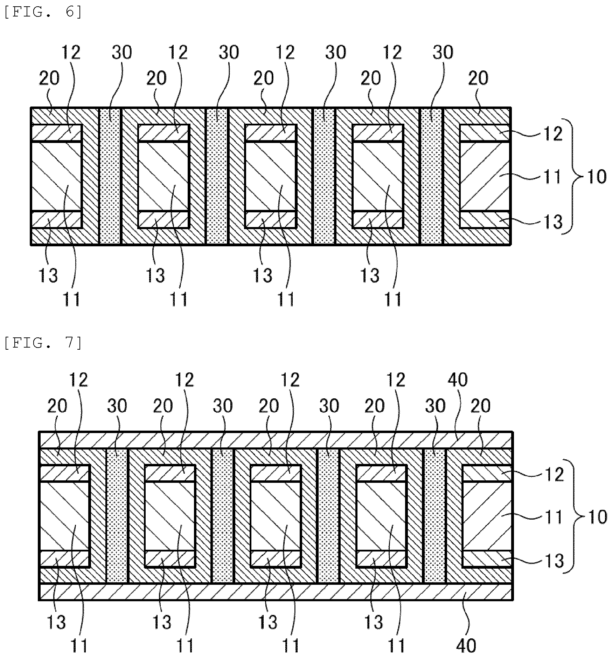

The step (2A) is a step in which at least part of the surface of the magnetic cured product is polished. At the step (2A), as illustrated in FIG. 6 as one example, an excess amount of the magnetic cured product 30 that is projected from or attached to the core substrate 10 is removed by polishing to flatten the surface thereof. The polishing method that can polish the excess amount of the magnetic cured product 30 that is projected from or attached to the core substrate 10 may be used. The polishing method like this is the same as those of the step (2) described before.

From a viewpoint to enhance the plating adhesion with the conductive layer, the arithmetic average roughness (Ra) of the polished surface of the magnetic cured product after the step (2A) is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) may be measured, for example, by using a non-contact type surface roughness meter.

By polishing the surface of the magnetic cured product at the step (2A), the conductive layer can be formed on the magnetic cured product without conducting the treatment by an oxidizing agent to the surface thereof. Accordingly, the magnetic cured product can be prevented from becoming brittle so that superior plating adhesion can be accomplished.

On the polished surface of the magnetic cured product thus obtained, part of (A) the magnetic powder containing nickel may be exposed; but, because the component (A) is resistant to an acid, generation of the foreign matters can be suppressed significantly.

Similarly to after the step (2) and before the step (3) as described before, after the step (2A) and before the step (3A), in order to further enhance the curing degree and the like of the magnetic cured product, a heat treatment step may be carried out as needed.

Step (2A-1)

The step (2A-1) is the conditioning step at which the surface of the magnetic cured product is treated with a solution containing a surfactant. At the step (2A-1), usually, by contacting the surface of the magnetic cured product with the solution containing the surfactant, not only the surface of the magnetic cured product is cleaned, but also the surface electric charge is controlled so that adsorption of the catalyst at the step (2A-2) may be facilitated.

As for the solution containing the surfactant that is used at the step (2A-1), any solution containing the surfactant may be used so far as the solution not only can clean the surface of the magnetic cured product but can also control the surface electric charge so that adsorption of the catalyst may be facilitated at the step (2A-2). Although examples of the solution like this include an alkaline solution containing the surfactant and an acidic solution containing the surfactant, from a viewpoint to suppress generation of the insoluble matters and the like, the alkaline solution containing the surfactant is preferable. Illustrative examples of the alkaline solution include a sodium hydroxide solution and a potassium hydroxide solution.

The value of pH of the alkaline solution containing the surfactant is preferably higher than 7, and more preferably 8 or higher, while still more preferably 10 or higher. Although the upper limit thereof is not particularly restricted, the value is preferably 14 or less, or may be 13 or less, or the like. The value of pH of the acidic solution containing the surfactant is preferably 1 or higher, and more preferably 2 or higher, while still more preferably 3 or higher. Although the upper limit thereof is not particularly restricted, the value is preferably less than 7, or may be 6 or less, or the like.

Illustrative examples of the surfactant include: cationic surfactants such as an alkylamine salt, an alkyl trimethylammonium salt, and an alkyl dimethyl benzylammonium salt; anionic surfactants such as aliphatic acid salts including sodium oleate, an alkyl sulfate salt, an alkylbenzene sulfonate salt, an alkyl sulfosuccinate salt, a naphthalene sulfonate salt, a polyoxyethylene alkylsulfate salt, a sodium alkanesulfonate salt, and a sodium alkyldiphenyl ether sulfonate salt; and nonionic-surfactants such as a polyoxyethylene nonyl phenyl ether, a polyoxyethylene lauryl ether, a polyoxyethylene styrylphenyl ether, a polyoxyethylene octylphenyl ether, a polyoxyethylene sorbitol tetraoleate, and a polyoxyethylene-polyoxypropylene copolymer.

Commercially available products may be used as the surfactant. Illustrative examples of the commercially available product include "Securiganth 902" manufactured by Atotech Japan Co., Ltd. and "PED-104" manufactured by C. Uyemura & Co., Ltd.

From a viewpoint to facilitate adsorption of the catalyst, the treatment period of the step (2A-1) is preferably 1 minute or longer, and more preferably 2 minutes or longer, while still more preferably 3 minutes or longer, and preferably 20 minutes or shorter, and more preferably 15 minutes or shorter, while still more preferably 10 minutes or shorter.

From a viewpoint to facilitate adsorption of the catalyst, the temperature of the solution containing the surfactant is preferably 30°C or higher, and more preferably 40°C or higher, while still more preferably 50°C or higher, and preferably 90°C or lower, and more preferably 80°C or lower, while still more preferably 70°C or lower.

After completion of the step (2A-1), cleaning with water may be carried out as needed.

Step (2A-1-1)

The step (2A-1-1) is the micro-etching step at which the surfactant is removed from the portion where the surfactant is unnecessary. At the step (2A-1-1), usually, by contacting a micro-etching solution with the surface of the magnetic cured product, the surfactant is removed from the portion where the surfactant is unnecessary. The portion where the surfactant is unnecessary includes, for example, the first metal layer 12 and the second metal layer 13.

Illustrative examples of the micro-etching solution include the solutions of hydrochloric acid, sulfuric acid, aqueous hydrogen peroxide, sodium persulfate, ammonium persulfate, as well as combinations of these solutions.

From a viewpoint to remove the surfactant only from the portion where the surfactant is unnecessary, the concentration of the micro-etching solution is, as normality, usually 2 N or lower, and preferably 1.5 N or lower, while more preferably 1 N or lower. From a viewpoint to facilitate removal of the surfactant, the concentration is preferably 0.1 N or higher, and more preferably 0.2 N or higher, while still more preferably 0.5 N or higher.

From a viewpoint to facilitate removal of the surfactant, the temperature of the micro-etching solution is preferably 10°C or higher, and more preferably 15°C or higher, while still more preferably 20°C or higher, and preferably 50°C or lower, and more preferably 40°C or lower, while still more preferably 30°C or lower.

From a viewpoint to facilitate removal of the surfactant, the treatment period of the step (2A-1-1) is preferably 10 seconds or longer, more preferably and 15 seconds or longer, while still more preferably 30 seconds or longer, and preferably 60 seconds or shorter, and more preferably 50 seconds or shorter, while still more preferably 40 seconds or shorter.

After completion of the step (2A-1-1), cleaning with water may be carried out as needed.

Step (2A-2)

The step (2A-2) is the catalyzing step at which the surface of the magnetic cured product is attached with a catalyst. At the step (2A-2), the surface of the magnetic cured product is attached with the catalyst so that the adhesion of the magnetic cured product with the conductive layer can be enhanced. Usually, at the step (2A-2), the magnetic cured product is soaked in the solution containing the catalyst so that the catalyst is adsorbed onto the surface of the magnetic cured product.

Illustrative examples of the catalyst include a palladium salt, a palladium complex compound, a tin/palladium complex salt, and a tin/palladium colloid.

The solution containing the catalyst is usually an alkaline solution. With this, generation of insoluble matters and the like can be suppressed significantly. The pH of this alkaline solution is preferably higher than 7, and more preferably 8 or higher, while still more preferably 10 or higher. The upper limit thereof is not particularly restricted; preferably this is 14 or lower, 13 or lower, or the like.

From a viewpoint to adsorb the catalyst to the whole of the magnetic cured product, the concentration of the solution containing the catalyst is, as normality, preferably 1 mmol/L or higher, and more preferably 5 mmol/L or higher, while still more preferably 10 mmol/L or higher, and preferably 500 mmol/L or lower, and more preferably 300 mmol/L or lower, while still more preferably 100 mmol/L or lower.

Commercially available products may be used as the solution containing the catalyst. Illustrative examples of the commercially available product include "Activator Neoganth 834" manufactured by Atotech Japan Co., Ltd. and "Brown Sumer" manufactured by Japan Kanigen Co., Ltd.

From a viewpoint to adsorb the catalyst to the whole of the magnetic cured product, the treatment period of the step (2A-2) is preferably 1 minute or longer, and more preferably 2 minutes or longer, while still more preferably 3 minutes or longer, and preferably 20 minutes or shorter, and more preferably 15 minutes or shorter, while still more preferably 10 minutes or shorter.

From a viewpoint to adsorb the catalyst to the whole of the magnetic cured product, the temperature of the solution containing the catalyst is preferably 10°C or higher, and more preferably 20°C or higher, while still more preferably 30°C or higher, and preferably 60°C or lower, and more preferably 50°C or lower, while still more preferably 40°C or lower.

After completion of the step (2A-2), cleaning with water may be carried out as needed.

Step (2A-3)

The step (2A-3) is the catalyst-activating step at which the catalyst is activated. At the step (2A-3), by activating the catalyst, the adhesion between the magnetic cured product with the conductive layer can be enhanced. Usually, at the step (2A-3), the magnetic cured product attached with the catalyst is soaked in a reducing agent solution to generate catalyst nuclei thereby activating the catalyst that is attached to the surface of the magnetic cured product.

Conventional, general magnetic powders (for example, metal powders not containing Ni) have been readily dissolved in the reducing agent solution. Part or all of the magnetic powder components dissolved therein can be readily precipitated by reduction with the reducing agent to generate foreign matters. However, the component (A) that is used in the present invention is sluggish in dissolution into the reducing agent solution so that generation of foreign matters can be suppressed.

Illustrative examples of the reducing agent that can be used at the step (2A-3) include a hypophosphate salt and a mixed solution of dimethylamine borane with a potassium salt of an organic acid.

Usually, an acidic solution is used as the reducing agent solution. The acidic solution like this can readily dissolve general magnetic powders. However, (A) the magnetic powder containing nickel is difficult to be soluble, so that generation of foreign matters and the like can be significantly suppressed. The pH of this acidic solution is preferably 1 or higher, more preferably 2 or higher, while still more preferably 3 or higher. Although there is no particular restriction in the upper limit thereof, the pH is preferably less than 7; while the pH may be 6 or less, or the like.

From a viewpoint to activate the catalyst that is attached to the surface of the magnetic cured product, the concentration of the reducing agent in the reducing agent solution is, as normality, preferably 0.3 N or higher, and more preferably 0.4 N or higher, while still more preferably 0.5 N or higher, and preferably 3 N or lower, and more preferably 2 N or lower, while still more preferably 1 N or lower.

Commercially available products may be used as the reducing agent solution. Illustrative examples of the commercially available product include "Reducer Accelerator 810 mod." and "Reducer Neoganth WA", both of which are manufactured by Atotech Japan Co., Ltd., and "K-PVD" manufactured by Japan Kanigen Co., Ltd.

From a viewpoint to activate the catalyst, the treatment period of the step (2A-3) is preferably 1 minute or longer, and more preferably 2 minutes or longer, while still more preferably 3 minutes or longer, and preferably 20 minutes or shorter, and more preferably 15 minutes or shorter, while still more preferably 10 minutes or shorter.

From a viewpoint to activate the catalyst, the temperature of the reducing agent solution is preferably 10°C or higher, and more preferably 20°C or higher, while still more preferably 30°C or higher, and preferably 60°C or lower, and more preferably 50°C or lower, while still more preferably 40°C or lower.

After completion of the step (2A-3), cleaning with water may be carried out as needed.

Step (3A)

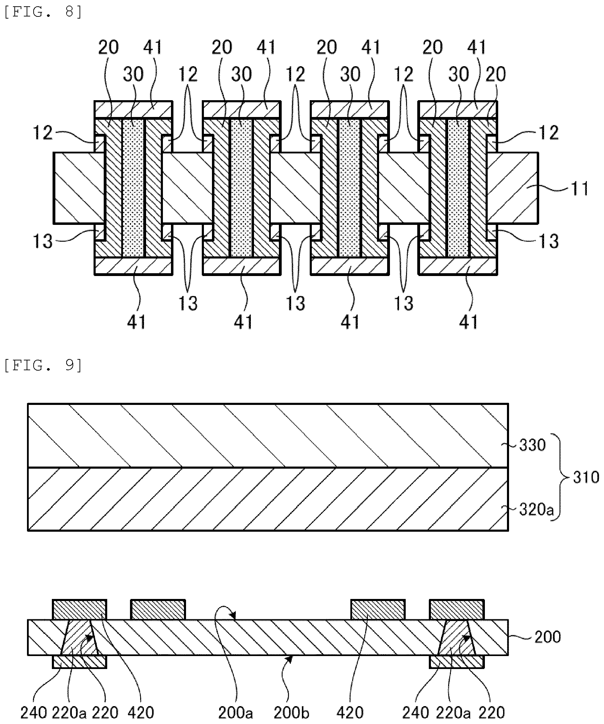

The step (3A) is the step at which a conductive layer is formed by wet plating on at least part of the polished surface of the magnetic cured product. At the step (3A), as illustrated in FIG. 7 as one example, a conductive layer 40 is formed by the wet plating on the polished magnetic cured product 30. Then, after the conductive layer 40 is formed, as illustrated in FIG. 8 as on example, by carrying out a treatment such as etching or the like, a patterned conductive layer 41 may be formed by removing part of the conductive layer 40, the first metal layer 12, the second metal layer 13, and the plated layer 20. As the materials, formation methods, and the like of the conductive layer 40 and patterned conductive layer 41 at the step (3A), the material, formation method, and the like of the conductive layer at the step (3) described above are applicable.

Second Embodiment

The circuit substrate according to the second embodiment includes a substrate including wiring and a magnetic cured product to seal and protect the wiring. An embodiment provided with the layered magnetic cured product can be exemplified. The production method of the circuit substrate according to the second embodiment includes:

(1B) a step at which a magnetic sheet is laminated onto a substrate in such a way that a resin composition layer is bonded to the substrate, which is followed by thermally curing the resin composition layer to form a magnetic cured product;
(2B) a step at which at least part of a surface of the magnetic cured product is polished, and
(3B) a step at which a conductive layer is formed by wet plating on at least part of the surface of the magnetic cured product thus polished, these steps being included in this order.

Preferably, the production method of the circuit substrate according to the second embodiment further includes, after the step (1B) and before the step (2B),
(1B-1) a step at which a hole-making process is carried out in the magnetic cured product.
More preferably, the method further includes, after the step (2B) and before the step (3B):

(2B-1) a conditioning step at which the surface of the magnetic cured product is treated with a solution containing a surfactant, and
(2B-2) a catalyzing step at which a catalyst is attached to the surface of the magnetic cured product, these steps being included in this order, while more preferably, the production method further includes, after the step (2B-2) and before the step (3B),
(2B-3) a catalyst-activating step at which the catalyst is activated.

In addition, the production method may include, after the step (2B-1) and before the step (2B-2),
(2B-1-1) a micro-etching step at which the surfactant is removed from the portion where the surfactant is unnecessary.

Step (1B)

The step (1B) is a step at which a magnetic sheet is laminated onto a substrate in such a way that a resin composition layer is bonded to the substrate, which is followed by thermally curing the resin composition layer to form a magnetic cured product. When carrying out the step (1B), this step may include a step to prepare the magnetic sheet.
At the step (1B), as illustrated in FIG. 9 as one example, a magnetic sheet 310 including a support 330 and a resin composition layer 320a formed on the support 330 is laminated onto an inner layer substrate 200 in such a way that the resin composition layer 320a is bonded to the inner layer substrate 200.
The inner layer substrate 200 is an insulating substrate. Illustrative examples of the material of the inner layer substrate 200 include insulating substrates such as a glass epoxy substrate, a metal substrate, a polyester substrate, a polyimide substrate, a BT resin substrate, and a thermosetting type polyphenylene ether substrate. The inner layer substrate 200 may be an inner layer circuit substrate having a wiring or the like incorporated in the thickness thereof.
As illustrated in FIG. 9 as one example, the inner layer substrate 200 has a first conductive layer 420 formed on a first main surface 200a and an outside terminal 240 formed on a second main surface 200b. The first conductive layer 420 includes a plurality of wirings. In the example illustrated by the drawing, only a wiring that constitutes a coil-like conductive structural body 400 of an inductor element is illustrated. The outside terminal 240 is a terminal to electrically connect to an outside device or the like that is not illustrated in the drawing. The outside terminal 240 may be constructed as part of the conductive layer formed on the second main surface 200b.
The conductive materials capable of constructing the first conductive layer 420, the outside terminal 240, and other conductive layers are the same as the material of the conductive layer that had been explained at the step (3) .

The first conductive layer 420, the outside terminal 240, and other conductive layers may be any of a monolayer structure and a multilayer structure in which two or more layers formed of single metal layers formed of different metals or of alloy layers are laminated. Thicknesses of the first conductive layer 420, of the outside terminal 240, and of other conductive layers are the same as those of the patterned conductive layer in the first embodiment.

The line (L)/space (S) ratio of the first conductive layer 420 and of the outside terminal 240 is not particularly restricted. From a viewpoint to reduce irregularity of the surface thereby obtaining the magnetic cured product that is excellent in the smoothness, the ratio is usually 900/900 um or less, preferably 700/700 um or less, more preferably 500/500 um or less, and still more preferably 300/300 um or less, while far still more preferably 200/200 um or less. The lower limit of the line/space ratio is not particularly restricted; from a viewpoint to enhance an embedding property of the resin composition layer into the space, the ratio is preferably 1/1 um or more.

The inner layer substrate 200 has a plurality of though holes 220 formed in such a way that these penetrate the inner layer substrate 200 from the first main surface 200a to the second main surface 200b. In the through hole 220, an inside-the-through-hole wiring 220a is formed. The inside-the-through-hole wiring 220a electrically connects the first conductive layer 420 with the outside terminal 240.

Bonding of the resin composition layer 320a to the inner layer substrate 200 may be carried out, for example, by hot-press bonding of the magnetic sheet 310 to the inner layer substrate 200 pressed from the side of the support 330. Illustrative examples of the component for hot-press bonding of the magnetic sheet 310 to the inner layer substrate 200 (hereinafter, this component is also called "hot-pressing component") include a heated metal plate (stainless steel (SUS) mirror plate or the like) and a heated metal roll (SUS roll). It is preferable that the hot-pressing component be not pressed directly to the magnetic sheet 310 but pressed via a sheet or the like formed of an elastic material such as a heat-resistant rubber so that the magnetic sheet 310 may well follow the surface irregularity of the inner layer substrate 200.

The temperature at the time of the hot-press bonding is preferably in the range of 80 to 160°C, and more preferably in the range of 90 to 140°C, while still more preferably in the range of 100 to 120°C. The pressure at the time of the hot-press bonding is preferably in the range of 0.098 to 1.77 MPa, while more preferably in the range of 0.29 to 1.47 MPa. The period at the time of the hot-press bonding is preferably in the range of 20 to 400 seconds, while more preferably in the range of 30 to 300 seconds. The bonding of the magnetic sheet to the inner layer substrate is carried out preferably under an evacuated condition with the pressure of 26.7 hPa or less.

Bonding of the resin composition layer 320a of the magnetic sheet 310 to the inner layer substrate 200 may be carried out by using a commercially available vacuum laminator. Illustrative examples of the commercially available vacuum laminator include a vacuum pressure type laminator manufactured by Meiki Co., Ltd. and a vacuum applicator manufactured by Nikko-Materials Co., Ltd.

After bonding of the magnetic sheet 310 to the inner layer substrate 200, under a normal pressure (under an atmospheric pressure), for example, the laminated magnetic sheet 31 may be flattened by pressing the hot-pressing component from the side of the support thereof. The pressing conditions of the flattening process can be the same as the hot-press bonding conditions in the beforementioned lamination. The flattening process may be carried out by using a commercially available laminator. Note that the lamination and the flattening processes may be carried out continuously by using the commercially available vacuum laminator described above.

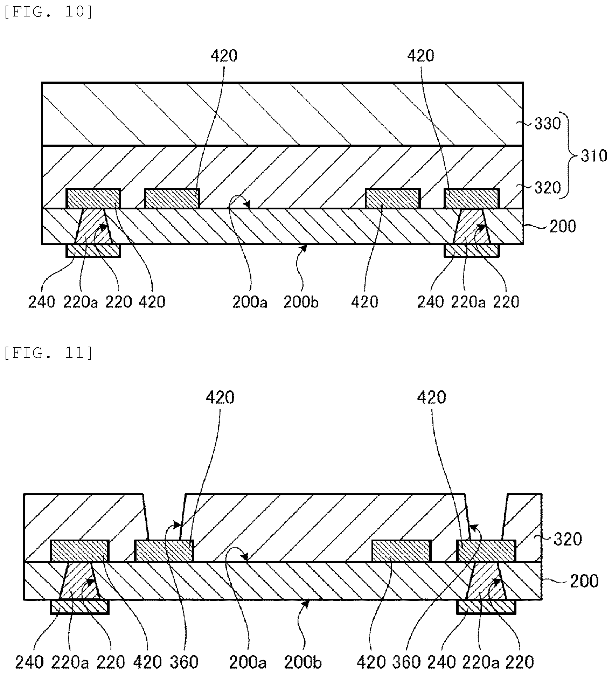

After the magnetic sheet is laminated to the inner layer substrate, the resin composition layer is thermally cured to form a magnetic cured product. As illustrated in FIG. 10 as one example, the resin composition layer 320a that is bonded to the inner layer substrate 200 is thermally cured to form a first magnetic cured product layer 320. The thermal curing condition of the resin composition layer 320a and the curing degree of the first magnetic cured product layer 320 are the same as the thermal curing condition and curing degree that had been explained at the step (1).

The support 330 may be removed between after thermal curing at the step (1B) and the step (2B), or after the step (2B).

The step (1B) may be carried out by directly applying or printing the paste-like resin composition (magnetic paste) onto the inner layer substrate instead of laminating the magnetic sheet onto the inner layer substrate.

Step (1B-1)

The step (1B-1) is the step at which a hole-making process is carried out in the magnetic cured product. At the step (1B-1), as illustrated in FIG. 11 as one example, a via hole 360 is formed by carrying out the hole-making process in the first magnetic cured product layer 320. The via hole 360 will be a channel to electrically connect the first conductive layer 420 with a second conductive layer 440 to be described later. Formation of the via hole 360 may be carried out with the same method as formation of the through hole that had been explained at the step (1).

Step (2B)

The step (2B) is the step at which at least part of a surface of the magnetic cured product is polished. The polishing method at the step (2B) is the same as the method that had been explained in the step (2A) according to the first embodiment.

From a viewpoint to enhance the plating adhesion with the conductive layer, the arithmetic average roughness (Ra) of the polished surface of the magnetic cured product after the step (2B) is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) may be measured, for example, by using a non-contact type surface roughness meter.

By polishing the surface of the magnetic cured product at the step (2B), the conductive layer can be formed on the magnetic cured product without conducting the treatment by an oxidizing agent to the surface thereof. Accordingly, the magnetic cured product can be prevented from becoming brittle, so that the superior plating adhesion can be accomplished.

On the polished surface of the magnetic cured product thus obtained, part of (A) the magnetic powder containing nickel may be exposed; but, because the component (A) is resistant to an acid, generation of the foreign matters can be suppressed significantly.

The steps (2B-1) to (2B-3) are the same as the steps (2A-1) to (2A-3) that had been explained in the first embodiment.

Step (3B)

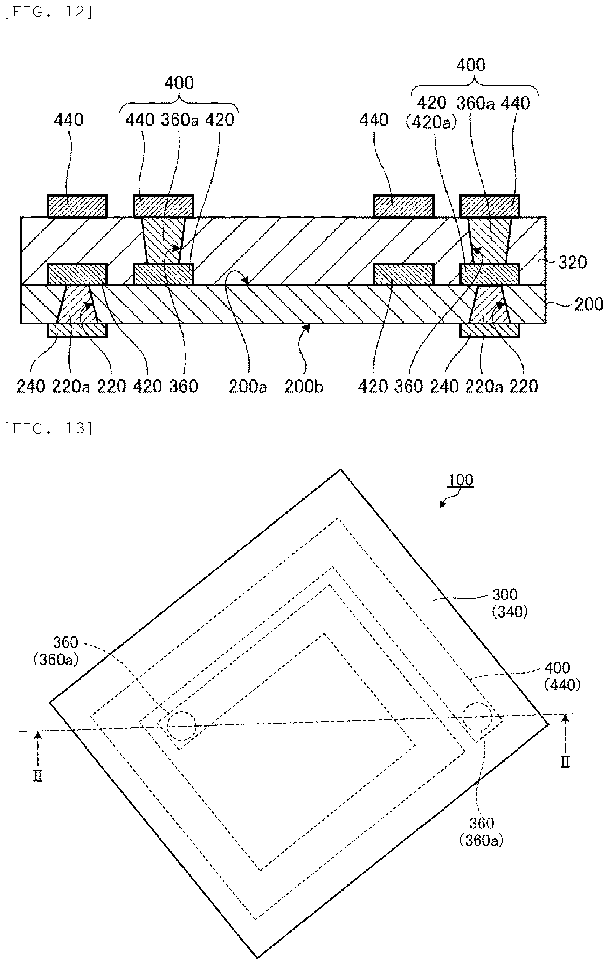

The step (3B) is the step at which the conductive layer is formed by the wet plating on at least part of the polished surface of the magnetic cured product. At the step (3B), as illustrated in FIG. 12 as one example, the second conductive layer 440 is formed on part of the polished surface of the first magnetic cured product layer 320. The formation method of the second conductive layer 440 is the same as the method that had been explained in the first embodiment. With this step, an inside-the-via-hole wiring 360a is simultaneously formed inside the via hole 360. The conductive layer 400 is formed by forming the second conductive layer 440. The second conductive layer 440 has a plurality of wirings.

The conductive material capable of constructing the second conductive layer 440 is the same as the material of the first conductive layer 420. The second conductive layer 440 may be any of a monolayer structure and a multilayer structure in which two or more layers formed of single metal layers formed of different metals or of alloy layers are laminated. When the second conductive layer 440 is of the multilayered structure, the layer that contacts with the magnetic cured product is preferably a single metal layer of chromium, zinc, or titanium, or an alloy layer of a nickel chromium alloy. The thickness of the second conductive layer 440 is the same as the thickness of the first conductive layer 420.

The first conductive layer 420 and the second conductive layer 440 may be formed, for example, spirally as illustrated in FIG. 13 to FIG. 15 to be described later as one example. In one example, one end in the center side of the spiral wiring part of the second conductive layer 440 is electrically connected through the inside-the-via-hole wiring 360a to one end in the center side of the spiral wiring part of the first conductive layer 420. Another end in the outer circumferential side of the spiral wiring part of the second conductive layer 440 is electrically connected through the inside-the-via-hole wiring 360a to a land 420a of the first conductive layer 42. Therefore, the other end in the outer circumferential side of the spiral wiring part of the second conductive layer 440 is electrically connected to the outside terminal 240 through the inside-the-via-hole wiring 360a, the land 420a, and the inside-the-through-hole wiring 220a.

The coil-like conductive structural body 400 is composed of the spiral wiring part that is part of the first conductive layer 420, the spiral wiring part that is part of the second conductive layer 440, and the inside-the-via-hole wiring 360a that electrically connects between the spiral wiring part of the first conductive layer 420 and the spiral wiring part of the second conductive layer 440.

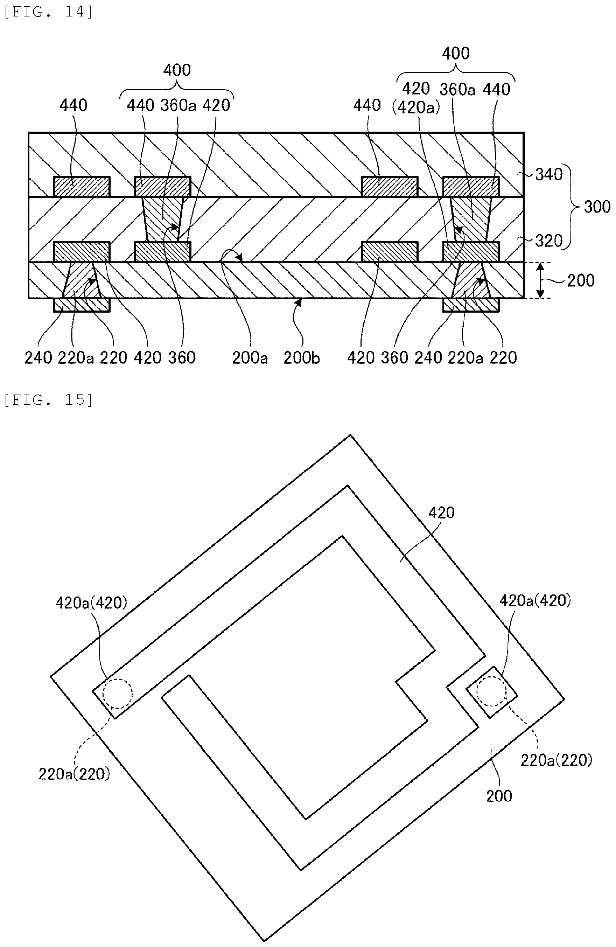

After the step (3B), a step to further form a magnetic cured product on the conductive layer may be carried out. Specifically, as illustrated in FIG. 14 as one example, a second magnetic cured product is formed on the first magnetic cured product layer 320 that has the second conductive layer 440 and the inside-the-via-hole wiring 360a formed therein. The second magnetic cured product may be formed with the same step as the step that has already been explained.

Magnetic Paste

By using a liquid epoxy resin and the like, the resin composition of the present invention can be made to a magnetic paste even without containing an organic solvent. When the magnetic paste contains the organic solvent, the content thereof relative to the total mass of the magnetic paste is preferably less than 1.0 % by mass, more preferably 0.8% or less by mass, and further preferably 0.5% or less by mass, while especially preferably 0.1% or less by mass. The lower limit thereof is not particularly restricted; here, the content is 0.001% or more by mass, or there is no organic solvent included therein. When the content of the organic solvent in the magnetic paste is low or there is no organic solvent included therein, not only generation of voids due to evaporation of the organic solvent can be suppressed, but also the handling property and workability thereof can be made excellent.

The viscosity of the magnetic paste at 25°C is preferably 20 Pa·s or more, and more preferably 25 Pa·s or more, while still more preferably 30 Pa·s or more, or 50 Pa·s or more, and usually less than 200 Pa·s, and preferably 180 Pa·s or less, while more preferably 160 Pa·s or less. The viscosity can be measured by using an E-type viscometer with keeping the temperature of the magnetic paste at 25±2°C.

The magnetic paste as mentioned above is useful when this is filled in the through hole of the substrate.

Magnetic Sheet

The magnetic sheet is formed of a support and a resin composition layer formed on the support, in which the resin composition layer is formed of the resin composition of the present invention.

From a viewpoint of thinning, the thickness of the resin composition layer is preferably 250 um or less, and more preferably 200 um or less, while still more preferably 150 um or less, or 100 um or less. Although the lower limit of the thickness of the resin composition layer is not particularly restricted, it can be usually made 5 um or more, or the like.

Illustrative examples of the support include a film formed of a plastic material, metal foil, and a releasing paper. Among these, a film formed of a plastic material and metal foil are preferable.

In the case that the film formed of a plastic material is used as the support, illustrative examples of the plastic material include: polyesters such as polyethylene terephthalate (hereinafter, this is also simply called "PET") and polyethylene naphthalate (hereinafter, this is also simply called "PEN"); polycarbonate (hereinafter, this is also simply called "PC"); acryls such as polymethyl methacrylate (PMMA); a cyclic polyolefins; triacetyl cellulose (TAC); polyether sulfide (PES); polyether ketone; and polyimide. Among these, polyethylene terephthalate and polyethylene naphthalate are preferable, while inexpensive polyethylene terephthalate is especially preferable.

In the case that metal foil is used as the support, illustrative examples of the metal foil include copper foil and aluminum foil, and copper foil is preferable. As for the copper foil, the foil formed of a copper single metal or an alloy of copper with other metal (for example, tin, chromium, silver, magnesium, nickel, zirconium, silicon, and titanium) may be used.

The support may be mat-treated or corona-treated on the surface to be bonded with the resin composition layer.

As for the support, a releasing layer-attached support having a releasing layer on the surface to be bonded with the resin composition layer may be used. The releasing agent to be used in the releasing layer of the releasing layer-attached support may be one or more releasing agents selected from the group consisting of, for example, an alkyd resin, a polyolefin resin, a urethane resin, and a silicone resin. A commercially available product may also be used as the releasing layer-attached support. Illustrative examples thereof include a PET film having a releasing layer formed of mainly an alkyd resin type releasing agent, such as "SK-1", "AL-5", and "AL-7", which are manufactured by Lintech Corp.; "Lumirror T60" manufactured by Toray Industries; "Purex" manufactured by Teijin Ltd.; and "Unipeel" manufactured by Unitika Ltd.

Although the thickness of the support is not particularly restricted, it is preferably in the range of 5 to 75 $\mu$m, while more preferably in the range of 10 to 60 um. When the releasing layer-attached support is used, total thickness of the releasing layer-attached support is preferably within this range.

The magnetic sheet may be produced, for example, as follows. Namely, the magnetic paste is prepared by dissolving the resin composition into an organic solvent; then, this magnetic paste is applied onto the support by means of a die coater or the like, followed by drying it to form the resin composition layer. When the resin composition is in the form of a paste, the resin composition layer may be formed by directly applying the resin composition onto the support by means of a die coater or the like.

Illustrative examples of the organic solvent include: ketones such as acetone, methyl ethyl ketone (MEK), and cyclohexanone; acetate esters such as ethyl acetate, butyl acetate, cellosolve acetate, propyleneglycol monomethyl ether acetate, and carbitol acetate; carbitols such as cellosolve and butyl carbitol; aromatic hydrocarbons such as toluene and xylene; and amide type solvents such as dimethylformamide, dimethylacetamide (DMAc), and N-methylpyrrolidone. These organic solvents may be used singly or as a combination of two or more of them.

Drying may be carried out by a heretofore known method such as heating, and blowing of hot air. The drying condition is not particularly restricted. Drying is carried out in such a way as to bring the content of the organic solvent in the resin composition layer to 10% or less by mass, while preferably to 5% or less by mass. In the case that the magnetic paste containing an organic solvent, for example, in the range of 30 to 60% by mass is used, the resin composition layer may be formed by drying thereof at 50 to 150°C for 3 to 10 minutes, although these conditions are different depending on the boiling point of the organic solvent contained in the magnetic paste.

In the magnetic sheet, a protection film in accordance with the support may be laminated onto the surface of the resin composition layer not bonded with the support (namely, the surface opposite to the support). The thickness of the protection film is not particularly restricted; the thickness is, for example, in the range of 1 to 40 um. By laminating the protection film, the resin composition layer may be prevented from attachment of dirt and the like as well as from a scar on the surface thereof. The magnetic sheet can be rolled up so as to be stored. In the case that the magnetic sheet has the protection film, the magnetic sheet can be used after the protection film is peeled off.

Inductor Part

The circuit substrate according to the present invention is preferably an inductor part having an inductor element formed with the patterned conductive layer.

The inductor part includes the circuit substrate that is obtained by the production method of the circuit substrate according to the present invention. When the inductor part includes the circuit substrate obtained by the first embodiment of the production method of the circuit substrate, the inductor part has an inductor element that is formed with a conductor at least in part of the circumference of the magnetic cured product of the resin composition. As for the inductor part like this, for example, the one that is described in Japanese Patent Application Laid-open No. 2016-197624 may be used.

When the inductor part includes the circuit substrate obtained by the second embodiment of the production method of the circuit substrate, the inductor part has the magnetic cured product of the resin composition (resin composition layer) and a conductive structural body having at least part thereof embedded into the magnetic cured product. The inductor part includes this conductive structural body and an inductor element that is extendedly present in a thickness direction of the magnetic cured product and is composed of part of the magnetic cured product surrounded with the conductive structural body. Note that FIG. 13 is a schematic plane view observed from one side in the thickness direction of the inductor part, which includes the inductor element therein. FIG. 14 is a schematic plane view illustrating a cut end face of the inductor part that is cut at the place indicated by the II-II one dot chain line illustrated in FIG. 13. FIG. 15 is a schematic plane view to explain the composition of the first conductive layer in the inductor part.

As illustrated in FIG. 13 and FIG. 14 as one example, an inductor part 100 has a plurality of the magnetic cured products (the first magnetic cured product layer 320 and the second magnetic cured product layer 340) and a plurality of the conductive layers (the first conductive layer 420 and the second conductive layer 440). Namely, this can be a build-up wiring board having a build-up magnetic cured product layer and a build-up conductive layer. In addition, the inductor part 100 has the inner layer substrate 200.

From FIG. 14, the first magnetic cured product layer 320 and the second magnetic cured product layer 340 constitute a magnetic member 300, which can be regarded as an integrated magnetic cured product. Therefore, the coil-like conductive structural body 400 is formed in such a way that at least part thereof is embedded into the magnetic member 300. Namely, in the inductor part 100 according to this embodiment, the inductor element is composed of the coil-like conductive structural body 400 and a core part, which is extendedly present in the thickness direction of the magnetic member 300 and is part of the magnetic member 300 that is surrounded with the coil-like conductive structural body 400.

As illustrated in FIG. 15 as one example, the first conductive layer 420 includes the spiral wiring to constitute the coil-like conductive structural body 400 and the land 420a in a square shape that is electrically connected to the inside-the-through-hole wiring 220a. In the example illustrated by the drawing, the spiral wiring includes a linear portion, a bent portion that is bent at a right angle to the linear portion, and a detour portion that detours the land 420a. In the example illustrated by the drawing, the entire outline of the spiral wiring part of the first conductive layer 420 is almost in a square shape and has a shape that is whirled in the counterclockwise direction from a center side to an outer side.

Similarly, the second conductive layer 440 is formed on the first magnetic cured product layer 320. The second conductive layer 440 includes the spiral wiring to constitute the coil-like conductive structural body 400. In FIG. 13 or FIG. 14, the spiral wiring includes a linear portion and a bent portion that is bent at a right angle to the linear portion. In FIG. 13 or FIG. 14, the entire of the outline of spiral wiring of the second conductive layer 44 is almost in a square shape and has a shape that is whirled in the clockwise direction from a center side to an outer side.

The inductor part can be used as the wiring board to mount an electronic part such as a semiconductor chip, and can also be used as a (multilayered) printed wiring board that uses this wiring board as the inner layer substrate. In addition, this can be used as a chip inductor part obtained by dicing the wiring board, and can also be used as a printed wiring board that is surface-mounted with the chip inductor part.

In addition, by using this wiring board, semiconductor devices with various embodiments may be produced. The semiconductor device having the wiring board like this can be suitably used in electric products (for example, a computer, a mobile phone, a digital camera, and a television), vehicles (for example, a motor bike, an automobile, a train, a marine ship, and an airplane), and so forth.

Resin Composition

The resin composition according to the present invention includes (A) a magnetic powder containing nickel,

(B) an epoxy resin, and (C) a curing agent. Furthermore, the resin composition optionally includes (D) a nonmagnetic inorganic filler, and as needed, can further include (E) other additives.

When the magnetic cured product of the resin composition as described above is used in production of the circuit substrate, the generation amount of the magnetic foreign matters that are producible in the treatment liquid at the wet plating process can be suppressed even when a polishing treatment is carried out in place of treating the surface of the magnetic cured product layer, so that fouling of the bath, the substrate, and the like can be prevented. In one embodiment, the resin composition according to the present invention includes the component (A), so that the magnetic cured product having the hardness suitable for polishing can be readily obtained. Accordingly, in this embodiment, the magnetic cured product of the resin composition according to the present invention is excellent in the polishing property. Hereinafter, each component in the resin composition according to the present invention will be explained.

(A) Magnetic Powder Containing Nickel

The resin composition according to the present invention includes (A) a magnetic powder containing nickel. Illustrative examples of the magnetic powder containing nickel include: a pure nickel powder; nickel-containing iron oxide powders such as a Ni-Zn type ferrite powder, a Ba-Ni type ferrite powder, and a Ba-Ni-Co type ferrite powder; and nickel iron alloy type metal powders such as a Fe-Ni-Cr type alloy powder, a Fe-Ni type alloy powder, a Fe-Ni-Mo type alloy powder, and a Fe-Ni-Mo-Cu type alloy powder.

Among the magnetic powders containing nickel, at least one powder selected from the nickel-containing iron oxide powder and the nickel iron alloy type metal powder is preferable, the nickel iron alloy type metal powder is more preferable, while the Fe-Ni type alloy powder and the Fe-Ni-Mo type alloy powder are especially preferable. The nickel-containing iron oxide powder may include, in addition to Fe and Ni, at least one metal selected from Cu, Mn, and Zn. The nickel iron alloy type metal powder may include the iron alloy type metal powder including, in addition to Fe and Ni, at least one metal selected from Si, Cr, Al, Mo, Cu, and Co.

From a viewpoint to clearly obtain the intended effect of the present invention, the content of nickel in the component (A) is, for example, 10% or more by mass, 20% or more by mass, or 30% or more by mass, preferably 35% or more by mass, and more preferably 40% or more by mass, while especially preferably 45% or more by mass. The upper limit value thereof is not particularly restricted; for example, the value may be 100% or less by mass, i.e., less than 100% by mass, 95% or less by mass, 90% or less by mass, 85% or less by mass, or the like.

The content of iron in the component (A) is not particularly restricted; for example, the content is 90% or less by mass, 80% or less by mass, or 70% or less by mass, preferably 65% or less by mass, and more preferably 60% or less by mass, while especially preferably 55% or less by mass. The lower limit value thereof is not particularly restricted; for example, the value may be 0% or more by mass, i.e., more than 0% by mass, 5% or more by mass, 10% or more by mass, 150 or more by mass, or the like.

Commercially available magnetic powders may be used as the component (A). Specifically, illustrative examples of the commercially available, usable magnetic powder include "MA-RCO-5" manufactured by DOWA Electronics Materials Co., Ltd. and "80% Ni-4Mo" manufactured by Epson Atmix Corp. The magnetic powders may be used singly, or two or more of them may be used concurrently.

The component (A) is preferably spherical. The value that is obtained by dividing a long axis with a short axis of the magnetic powder (aspect ratio) is preferably 2 or less, and more preferably 1.5 or less, while still more preferably 1.2 or less. In general, the magnetic powder in a flat shape can have a higher relative permeability than a spherical shape. On the other hand, especially the spherical magnetic powder is preferable not only because a magnetic loss can usually be reduced but also from a viewpoint to obtain the paste having a preferable viscosity.

From a viewpoint to enhance the relative permeability, the average particle diameter of the component (A) is preferably 0.01 um or more, and more preferably 0.5 um or more, while still more preferably 1 um or more. In addition, this is preferably 30 um or less, and more preferably 20 um or less, while still more preferably 10 um or less.

The average particle diameter of the component (A) may be measured with a laser diffraction scattering method based on the Mie scattering theory. Specifically, the particle diameter distribution of the magnetic powder is prepared on the basis of a volume standard by using a laser diffraction scattering type particle diameter distribution measurement instrument, in which a median diameter thereof may be measured as the average particle diameter thereof. The magnetic powders that are dispersed in water by means of an ultrasonic wave may be preferably used as the measurement sample. Illustrative examples of the laser diffraction scattering type particle diameter distribution measurement instrument include "LA-500" manufactured by Horiba Ltd. and "SALD-2200" manufactured by Shimadzu Corp.

From a viewpoint to enhance the relative permeability, the specific surface area of the component (A) is preferably 0.05 $m^2$/g or more, and more preferably 0.1 $m^2$/g or more, while still more preferably 0.3 $m^2$/g or more. In addition, this is preferably 10 $m^2$/g or less, and more preferably 8 $m^2$/g or less, while still more preferably 5 $m^2$/g or less. The specific surface area of the magnetic powder may be measured by the BET method.

From a viewpoint to clearly obtain the intended effect of the present invention, the undissolution rate of the component (A) during soaking in an acidic solution, i.e., the weight retention rate, for example upon soaking in 2 N sulfuric acid at 40°C for 5 minutes, is preferably 70% or more, more preferably 80% or more, and still more preferably 90% or more, while especially preferably 95% or more.

From a viewpoint to enhance the relative permeability and to lower the loss factor, the content (% by volume) of the component (A) is, on the basis of 100% by volume of the nonvolatile components in the resin composition, preferably 10% or more by volume, more and preferably 20% or more by volume, while still more preferably 30% or more by volume. In addition, the content is preferably 85% or less by volume, and more preferably 80% or less by volume, while still more preferably 75% or less by volume.

From a viewpoint to enhance the relative permeability and to lower the loss factor, the content (% by mass) of the component (A) is, on the basis of 100% by mass of the nonvolatile components in the resin composition, preferably 70% or more by mass, and more preferably 75% or more by mass, while still more preferably 78% or more by mass. In addition, the content is preferably 98% or less by mass, and more preferably 95% or less by mass, while still more preferably 90% or less by mass.

(B) Epoxy Resin

The resin composition according to the present invention includes (B) an epoxy resin.

Illustrative examples of (B) the epoxy resin include a bixylenol type epoxy resin, a bisphenol A type epoxy resin, a bisphenol F type epoxy resin, a bisphenol S type epoxy resin, a bisphenol AF type epoxy resin, a dicyclopentadiene type epoxy resin, a trisphenol type epoxy resin, a naphthol novolak type epoxy resin, a phenol novolak type epoxy resin, a tert-butyl-catechol type epoxy resin, a naphthalene type epoxy resin, a naphthol type epoxy resin, an anthracene type epoxy resin, a glycidyl amine type epoxy resin, a glycidyl ester type epoxy resin, a cresol novolak type epoxy resin, a biphenyl type epoxy resin, a linear aliphatic epoxy resin, an epoxy resin having a butadiene structure, an alicyclic epoxy resin, a heterocyclic epoxy resin, an epoxy resin having a spiro ring, a cyclohexane type epoxy resin, a cyclohexane dimethanol type epoxy resin, a naphthylene ether type epoxy resin, a trimethylol type epoxy resin, and a tetraphenylethane type epoxy resin. These epoxy resins may be used singly or as a combination of two or more of them.

It is preferable that the resin composition include, as (B) the epoxy resin, an epoxy resin having two or more epoxy groups in one molecule. From a viewpoint to clearly obtain the intended effect of the present invention, the ratio of the epoxy resin having two or more epoxy groups in one molecule is preferably 50% or more by mass, and more preferably 60% or more by mass, while especially preferably 70% or more by mass, on the basis of 100% by mass of the nonvolatile components in (B) the epoxy resin.

In the epoxy resin, there are an epoxy resin that is in the state of liquid at 25°C (hereinafter, this is also called "liquid epoxy resin") and an epoxy resin that is in the state of solid at 25°C (hereinafter, this is also called "solid epoxy resin"). In one embodiment, the resin composition according to the present invention includes, as the epoxy resin, the liquid epoxy resin. In one embodiment, the resin composition according to the present invention includes, as the epoxy resin, the solid epoxy resin. The resin composition according to the present invention may include, as the epoxy resin, only the liquid epoxy resin, or only the solid epoxy resin, or the liquid epoxy resin and the solid epoxy resin as a combination. According to the preferred embodiment, only the liquid epoxy resin is included therein.

As for the liquid epoxy resin, the liquid epoxy resin having two or more epoxy groups in one molecule thereof is preferable.

The liquid epoxy resin is preferably a bisphenol A type epoxy resin, a bisphenol F type epoxy resin, a bisphenol AF type epoxy resin, a naphthalene type epoxy resin, a glycidyl ester type epoxy resin, a glycidyl amine type epoxy resin, a phenol novolak type epoxy resin, an alicyclic epoxy resin having an ester skeleton, a cyclohexane type epoxy resin, a cyclohexane dimethanol type epoxy resin, a glycidyl amine type epoxy resin, and an epoxy resin having a butadiene structure.

Specifically, illustrative examples of the liquid epoxy resin include "HP4032", "HP4032D", and "HP4032SS" (these are naphthalene type epoxy resins) manufactured by DIC Corp.; "828US", "828EL", "jER828EL", "825", and "Epikote 828EL" (these are bisphenol A type epoxy resins) manufactured by Mitsubishi Chemical Corp.; "jER807" and "1750" (both are bisphenol F type epoxy resins) manufactured by Mitsubishi Chemical Corp.; "jER152" (a phenol novolak type epoxy resin) manufactured by Mitsubishi Chemical Corp.; "630" and "630LSD" (both are glycidyl amine type epoxy resins) manufactured by Mitsubishi Chemical Corp.; "ZX1059" (a mixture of a bisphenol A type epoxy resin and a bisphenol F type epoxy resin) manufactured by Nippon Steel Sumikin Chemical Co., Ltd.; "EX-721" (a glycidyl ester type epoxy resin) manufactured by Nagase ChemteX Corp.; "Celloxide 2021P" (an alicyclic epoxy resin having an ester skeleton) manufactured by Daicel Corp.; "PB-3600" manufactured by Daicel Corp., "JP-100" and "JP-200" both of which are manufactured by Nippon Soda Co., Ltd. (all these three are epoxy resins having a butadiene skeleton); and "ZX1658" and "ZX1658GS" (both are liquid 1,4-glycidylcyclohexane type epoxy resins) manufactured by Nippon Steel Sumikin Chemical Co., Ltd. These may be used singly or as a combination of two or more of them.

As for the solid epoxy resin, the solid epoxy resin having three or more epoxy groups in one molecule thereof is preferable, while the aromatic solid epoxy resin having three or more epoxy groups in one molecule thereof is more preferable.

The solid epoxy resin is preferably a bixylenol type epoxy resin, a naphthalene type epoxy resin, a naphthalene type four-functional epoxy resin, a cresol novolak type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, a bisphenol AF type epoxy resin, and a tetraphenylethane type epoxy resin.

Specifically, illustrative examples of the solid epoxy resin include "HP4032H" (a naphthalene type epoxy resin) manufactured by DIC Corp.; "HP-4700" and "HP-4710" (both are naphthalene type four-functional epoxy resins) manufactured by DIC Corp.; "N-690" (a cresol novolak type epoxy resin) manufactured by DIC Corp.; "N-695" (a cresol novolak type epoxy resin) manufactured by DIC Corp.; "HP-7200" (a dicyclopentadiene type epoxy resin) manufactured by DIC Corp.; "HP-7200HH", "HP-7200H", "EXA-7311", "EXA-7311-G3", "EXA-7311-G4", "EXA-7311-G4S", and "HP6000" (these are naphthylene ether type epoxy resins) manufactured by DIC Corp.; "EPPN-502H" (a trisphenol type epoxy resin) manufactured by Nippon Kayaku Co., Ltd.; "NC7000L" (a naphthol novolak type epoxy resin) manufactured by Nippon Kayaku Co., Ltd.; "NC3000H", "NC3000", "NC3000L", and "NC3100" (these are biphenyl type epoxy resins) manufactured by Nippon Kayaku Co., Ltd.; "ESN475V" (a naphthalene type epoxy resin) manufactured by Nippon Steel Sumikin Chemical Co., Ltd.; "ESN485" (a naphthol novolak type epoxy resin) manufactured by Nippon Steel Sumikin Chemical Co., Ltd.; "YX4000H", "YX4000", and "YL6121" (these are biphenyl type epoxy resins) manufactured by Mitsubishi Chemical Corp.; "YX4000HK" (a bixylenol type epoxy resin) manufactured by Mitsubishi Chemical Corp.; "YX8800" (an anthracene type epoxy resin) manufactured by Mitsubishi Chemical Corp.; "YX7700" (a novolak type epoxy resin having a xylene structure) manufactured by Mitsubishi Chemical Corp.; "PG-100" and "CG-500" manufactured by Osaka Gas Chemicals Co., Ltd.; "YL7760" (a bisphenol AF type epoxy resin) manufactured by Mitsubishi Chemical Corp.; "YL7800" (a fluorene type epoxy resin) manufactured by Mitsubishi Chemical Corp.; "jER1010" (a solid bisphenol A type epoxy resin) manufactured by Mitsubishi Chemical Corp.; and "jER1031S" (a tetraphenylethane type epoxy resin) manufactured by Mitsubishi Chemical Corp. These may be used singly or as a mixture of two or more of them.

When (B) the epoxy resin is used as a combination of the liquid epoxy resin with the solid epoxy resin, the mass ratio of the liquid epoxy resin to the solid epoxy resin (liquid epoxy resin/solid epoxy resin) is preferably 1 or more, and more preferably 10 or more, while especially preferably 50 or more.

The epoxy equivalent of (B) the epoxy resin is preferably in the range of 50 to 5,000 g/eq., more preferably in the range of 50 to 3,000 g/eq., and still more preferably in the range of 80 to 2,000 g/eq., while far still more preferably in the range of 110 to 1,000 g/eq. Within this range, the crosslinking density of the magnetic cured product in the magnetic sheet is sufficient, so that the magnetic cured product layer having a small surface roughness can be obtained. The epoxy equivalent is the mass of the resin having one equivalent of the epoxy group. The epoxy equivalent may be measured in accordance with JIS K7236.

From a viewpoint to clearly obtain the intended effect of the present invention, the weight-average molecular weight (Mw) of (B) the epoxy resin is preferably in the range of 100 to 5,000, and more preferably in the range of 250 to 3,000, while still more preferably in the range of 400 to 1500. The weight-average molecular weight of the resin may be measured in terms of polystyrene by a gel permeation chromatography (GPC) method.

Although the content of (B) the epoxy resin is not particularly restricted, from a viewpoint to clearly obtain the intended effect of the present invention, the content is preferably 1% or more by mass, more preferably 5% or more by mass, and still more preferably 8% or more by mass, while especially preferably 10% or more by mass, on the basis of 100% by mass of the nonvolatile components in the resin composition. From a viewpoint to clearly obtain the intended effect of the present invention, the upper limit thereof is preferably 50% or less by mass, more preferably 40% or less by mass, and still more preferably 30% or less by mass, while especially preferably 20% or less by mass.

(C) Curing Agent

The resin composition according to the present invention includes (C) the curing agent.

There is no particular restriction in (C) the curing agent so far as this has a function to cure the epoxy resin. Illustrative examples thereof include a phenol type curing agent, a naphthol type curing agent, an acid anhydride type curing agent, an active ester type curing agent, a benzoxazine type curing agent, a cyanate ester type curing agent, a carbodiimide type curing agent, a phosphorous type curing agent, an amine type curing agent, an imidazole type curing agent, a guanidine type curing agent, and a metal type curing agent. Among these, an acid anhydride type curing agent, an amine type curing agent, and an imidazole type curing agent are preferable. (C) The curing agent may be used singly or as a combination of two or more of the above-mentioned curing agents.

In view of a heat resistance and a water resistance, it is preferable that the phenol type curing agent and the naphthol type curing agent be a phenol type curing agent having a novolak structure, or a naphthol type curing agent having a novolak structure. In view of the adhesion property to a body to be adhered, a nitrogen-containing phenol type curing agent or a nitrogen-containing naphthol type curing agent is preferable, while a phenol type curing agent having a triazine skeleton or a naphthol type curing agent having a triazine skeleton is more preferable. In particular, in view of highly satisfying a heat resistance, a water resistance, and an adhesion property, a phenol novolak resin having a triazine skeleton is preferable. Specific examples of the phenol type curing agent and the naphthol type curing agent include: "MEH-7700", "MEH-7810", "MEH-7851", and "MEH-8000H" manufactured by Meiwa Plastic Industries, Ltd.; "NHN", "CBN", and "GPH" manufactured by Nippon Kayaku Co., Ltd.; "SN-170", "SN-180", "SN-190", "SN-475", "SN-485", "SN-495", "SN-375", and "SN-395" manufactured by Nippon Steel Sumikin Chemical Co., Ltd.; and "LA-7052", "LA-7054", "LA-3018", "LA-3018-50P", "LA-1356", and "TD2090" manufactured by DIC Corp.

The acid anhydride type curing agent may be the curing agent having one or more acid anhydride groups in one molecule thereof. Specifically, illustrative examples of the acid anhydride type curing agent include phthalic anhydride, tetrahydrophthalic anhydride, hexahydrophthalic anhydride, methyltetrahydrophthalic anhydride, methylhexahydrophthalic anhydride, methyl nadic anhydride, hydrogenated methyl nadic anhydride, trialkyl tetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphtho[1,2-C]furan-1,3-dione, ethyleneglycol bis(anhydrotrimellitate), methylbicyclo[2.2.1]heptane-2,3-dicarboxylic anhydride/bicyclo[2.2.1]heptane-2,3-dicarboxylic anhydride ("HNA-100": commercially available product manufactured by New Japan Chemical Co., Ltd.), and a polymer type acid anhydride such as a styrene-maleic acid resin, which is a copolymer of styrene and maleic acid.

There is no particular restriction in the active ester type curing agent. In general, compounds having two or more ester groups having a high reactivity in one molecule can be preferably used. Illustrative examples of the highly reactive ester groups include phenol esters, thiophenol esters, N-hydroxylamine esters, and esters of heterocyclic hydroxy compounds. The active ester type curing agent is preferably a compound that is obtained by a condensation reaction of a carboxylic acid compound and/or a thiocarboxylic acid compound with a hydroxy compound and/or with a thiol compound. In particular, from a viewpoint to enhance a heat resistance, an active ester type curing agent obtained from a carboxylic acid compound and a hydroxy compound is preferable, while an active ester type curing agent obtained from a carboxylic acid compound and a phenol compound and/or a naphthol compound is more preferable. Illustrative examples of the carboxylic acid compound include benzoic acid, acetic acid, succinic acid, maleic acid, itaconic acid, phthalic acid, isophthalic acid, terephthalic acid, and pyromellitic acid. Illustrative examples of the phenol compound or the naphthol compound include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, $\alpha$-naphthol, $\beta$-naphthol, 1,5-dihydroxy naphthalene, 1,6-dihydroxy naphthalene, 2,6-dihydroxy naphthalene, dihydroxy benzophenone, trihydroxy benzophenone, tetrahydroxy benzophenone, phloroglucin, benzene triol, a dicyclopentadiene type diphenol compound, and phenol novolak. Here, the "dicyclopentadiene type diphenol compound" means a diphenol compound obtained by condensation of one dicyclopentadiene molecule with two phenol molecules.

Specifically, an active ester compound containing a dicyclopentadiene type diphenol structure, an active ester compound containing a naphthalene structure, an active ester compound containing an acetylated phenol novolak, and an active ester compound containing a benzoylated phenol novolak are preferable; among these, the active ester compound containing a naphthalene structure and the active ester compound containing a dicyclopentadiene type diphenol structure are more preferable. Here, the "dicyclopentadiene type diphenol structure" means a divalent structural unit formed of phenylene-dicyclopentalene-phenylene.

Illustrative examples of the commercially available product of the active ester type curing agent include: as the active ester compound containing a dicyclopentadiene type diphenol structure, "EXB9451", "EXB9460", "EXB9460S", "HPC-8000", "HPC-8000H", "HPC-8000-65T", "HPC-8000H-65TM", "EXB-8000L", and "EXB-8000L-65TM" (these are manufactured by DIC Corp.); as the active ester compound containing a naphthalene structure, "EXB9416-70BK" and "EXB-8150-65T" (these are manufactured by DIC Corp.); as the active ester compound containing an acetylated phenol novolak, "DC808" (manufactured by Mitsubishi Chemical Corp.); as the active ester compound containing a benzoylated phenol novolak, "YLH1026" (manufactured by Mitsubishi Chemical Corp.); as the active ester type curing agent that is acetylated phenol novolak, "DC808" (manufactured by Mitsubishi Chemical Corp.); and as the active ester type curing agent that is benzoylated phenol novolak, "YLH1026" (manufactured by Mitsubishi Chemical Corp.), "YLH1030" (manufactured by Mitsubishi Chemical Corp.), and "YLH1048" (manufactured by Mitsubishi Chemical Corp.).

Specific examples of the benzoxazine type curing agent include "JBZ-OP100D" and "ODA-BOZ" manufactured by JFE Chemical Corp.; "HFB2006M" manufactured by Showa Highpolymer Co., Ltd.; and "P-d" and "F-a" manufactured by Shikoku Chemicals Corp.

Illustrative examples of the cyanate ester type curing agent include: bifunctional cyanate resins such as bisphenol A dicyanate, polyphenol cyanate (oligo(3-methylene-1,5-phenylenecyanate)), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl)thioether, and bis(4-cyanatephenyl) ether; polyfunctional cyanate resins derived from a phenol novolak, a cresol novolak, and the like; and a prepolymer in which these cyanate resins are partially made to triazine. Specific examples of the cyanate ester type curing agent include "PT30" and "PT60" (both are phenol novolak type polyfunctional cyanate ester resins); and "BA230" and "BA230S75" (both are prepolymers in which part or all of bisphenol A dicyanate is made to triazine so as to be a trimer); all of these agents being manufactured by Lonza Japan Ltd.

Specific examples of the carbodiimide type curing agent include "V-03" and "V-07" manufactured by Nisshinbo Chemical, Inc.

Illustrative examples of the phosphorous type curing agent include triphenylphosphine, phosphonium borate compounds, tetraphenylphosphonium tetraphenyl borate, n-butylphosphonium tetraphenyl borate, tetrabutylphosphonium decanoate, (4-methylphenyl) triphenylphosphonium thiocyanate, tetraphenylphosphonium thiocyanate, and butyl triphenylphosphonium thiocyanate.

Illustrative examples of the amine type curing agent include: aliphatic amine type curing agents such as triethylamine, tributylamine, 4-dimethylaminopyridine (DMAP), benzyl dimethylamine, 2,4,6-tris(dimethylaminomethyl)phenol, and 1,8-diazabicyclo(5,4,0)-undecene, as well as 4-dimethylaminopyridine and 1,8-diazabicyclo(5,4,0)-undecene; and aromatic amine type curing agents such as benzidine, o-tolidine, 4,4'-diaminodiphenylmethane, 4,4'-diamino-3,3'-dimethyldiphenylmethane ("Kayabond C-100": commercially available product manufactured by Nippon Kayaku Co., Ltd.), 4,4'-diamino-3,3'-diethyldiphenylmethane ("Kayahard A-A": commercially available product manufactured by Nippon Kayaku Co., Ltd.), 4,4'-diamino-3,3',5,5'-tetramethyldiphenylmethane ("Kayabond C-200S": commercially available product manufactured by Nippon Kayaku Co., Ltd.), 4,4'-diamino-3,3',5,5'-tetraethyldiphenylmethane ("Kayabond C-300S": commercially available product manufactured by Nippon Kayaku Co., Ltd.), 4,4'-diamino-3,3'-diethyl-5,5'-dimethyldiphenylmethane, 4,4'-diaminodiphenyl ether, 1,3-bis(3-aminophenoxy)benzene, 1,3-bis(4-aminophenoxy)benzene, 1,4-bis(3-aminophenoxy)benzene, 1,4-bis(4-aminophenoxy)benzene, 1,3-bis(4-aminophenoxy)neopentane, 4,4'-[1,3-phenylenebis(1-methyl-ethylydene) ]bisaniline ("Bisaniline M": commercially available product manufactured by Mitsui Chemicals, Inc.), 4,4'-[1,4-phenylenebis(1-methyl-ethylydene)]bisaniline ("Bisaniline P": commercially available product manufactured by Mitsui Chemicals, Inc.), 2,2-bis[4-(4-aminophenoxy)phenyl]propane ("BAPP": commercially available product manufactured by Wakayama Seika Kogyo Co., Ltd.), 2,2-bis[4-(4-aminophenoxy)phenyl]hexafluoropropane, and 4,4'-bis(4-aminophenoxy)biphenyl.

Illustrative examples of the imidazole type curing agent include imidazole compounds such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-bezyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-metylimidazolyl-(1')]-ethyl-s-triazine, 2,4-diamino-6-[2'-methylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrro[1,2-a]benzimidazole, 1-dodecyl-2-methyl-3-benzylimidazolium chloride, 2-methylimidazoline, and 2-phenylimidazoline; and adducts of these imidazole compounds with an epoxy resin.

Commercially available imidazole type curing agent may be used. Illustrative examples thereof include "P200-H50" manufactured by Mitsubishi Chemical Corp.

Illustrative examples of the guanidine type curing agent include dicyandiamide, 1-methylguanidine, 1-ethylguanidine, 1-cyclohexylguanidine, 1-phenylguanidine, 1-(o-tolyl)guanidine, dimethylguanidine, diphenylguanidine, trimethylguanidine, tetramethylguanidine, pentamethylguanidine, 1,5,7-triazabicyclo[4.4.0]deca-5-ene, 7-methyl-1,5,7-triazabicyclo[4.4.0]deca-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, and 1-(o-tolyl)biguanide.

Illustrative examples of the metal type curing agent include organic metal complexes or organic metal salts of metals such as cobalt, copper, zinc, iron, nickel, manganese, and tin. Specific examples of the organic metal complex include organic cobalt complexes such as cobalt (II) acetylacetonate and cobalt (III) acetylacetonate; organic copper complexes such as copper (II) acetylacetonate; organic zinc complexes such as zinc (II) acetylacetonate; organic iron complexes such as iron (III) acetylacetonate; organic nickel complexes such as nickel (II) acetylacetonate; and organic manganese complexes such as manganese (II) acetylacetonate. Illustrative examples of the organic metal salt include zinc octylate, tin octylate, zinc naphthenate, cobalt naphthenate, tin stearate, and zinc stearate.

The quantity ratio of the epoxy resin to the curing agent in terms of the ratio of [total number of the epoxy groups in the epoxy resins] to [total number of the reactive groups in the curing agent] is preferably in the range of 1:0.2 to 1:2, and more preferably in the range of 1:0.3 to 1:1.5, while still more preferably in the range of 1:0.4 to 1:1.2. Note that the reactive group of the curing agent means an active hydroxy group, an active ester group, and the like. These are different depending on the curing agent. The total number of the epoxy groups in the epoxy resin means the total value of the values obtained by dividing the mass of the nonvolatile components in all the epoxy resins with the epoxy equivalent. The total number of the reactive groups in the curing agent means the total value of the values obtained by dividing the mass of the nonvolatile components in all the curing agents with the equivalent of the reactive group. When the quantity ratio of the epoxy resin to the curing agent is brought within this range, the heat resistance of the cured product thereby obtained can be enhanced furthermore.

Although the content of (C) the curing agent is not particularly restricted, the content is preferably 0.01% or more by mass, and more preferably 0.1% or more by mass, while still more preferably 0.5% or more by mass, on the basis of 100% by mass of the nonvolatile components in the resin composition. The upper limit thereof is preferably 10% or less by mass, and more preferably 5% or less by mass, while still more preferably 2% or less by mass.

(D) Nonmagnetic Inorganic Filler

The resin composition according to the present invention can optionally include (D) a nonmagnetic inorganic filler as an arbitrary component. (D) The nonmagnetic inorganic filler is the component not having a magnetic property, which is different from the component (A) .

The material of (D) the nonmagnetic inorganic filler is not particularly restricted. Illustrated examples thereof include silica, alumina, glass, cordierite, silicon oxide, barium sulfate, barium carbonate, talc, clay, mica powder, zinc oxide, hydrotalcite, boehmite, aluminum hydroxide, magnesium hydroxide, calcium carbonate, magnesium carbonate, magnesium oxide, boron nitride, aluminum nitride, manganese nitride, aluminum borate, strontium carbonate, strontium titanate, calcium titanate, magnesium titanate, bismuth titanate, titanium oxide, zirconium oxide, barium titanate, barium titanate zirconate, barium zirconate, calcium zirconate, zirconium phosphate, and zirconium phosphate tungstate. Among these, silica is especially preferable. Illustrative examples of the silica include amorphous silica, fused silica, crystalline silica, synthesized silica, and hollow silica. Spherical silica is preferable as the silica. (D) The nonmagnetic inorganic filler may be used singly or as a combination of two or more of them.

Illustrative examples of the commercially available product of (D) the nonmagnetic inorganic filler include: "RY-200" and "A200" manufactured by Nippon Aerosil Co., Ltd.; "UFP-30" manufactured by Denka Co., Ltd.; "SP60-05" and "SP507-05" manufactured by Nippon Steel & Sumikin Materials Co., Ltd.; "YC100C", "YA050C", "YA050C-MJE", and "YA010C" manufactured by Admatechs Co., Ltd.; "UFP-30" manufactured by Denka Co., Ltd.; "Silfil NSS-3N", "Silfil NSS-4N", and "Silfil NSS-5N" manufactured by Tokuyama Corp.; and "SC2500SQ", "SO-C4", "SO-C2", and "SO-C1" manufactured by Admatechs Co., Ltd.

Although the average particle diameter of (D) the nonmagnetic inorganic filler is not particularly restricted, from a viewpoint to obtain the intended effect of the present invention, the average diameter is preferably 20 μm or less, more preferably 10 μm or less, still more preferably 8 μm or less, and far still more preferably 6 μm or less, while especially preferably 5 μm or less. From a viewpoint to obtain the intended effect of the present invention, the lower limit of the average particle diameter of the nonmagnetic inorganic filler is preferably 0.1 μm or more, more preferably 1 μm or more, still more preferably 2 μm or more, and far still more preferably 3 μm or more, while especially preferably 4 μm or more. The average particle diameter of the nonmagnetic inorganic filler may be measured with a laser diffraction/scattering method based on the Mie scattering theory. Specifically, the particle diameter distribution of the nonmagnetic inorganic filler on the volume basis is prepared by means of a laser diffraction scattering type particle diameter distribution measurement apparatus, and the average particle diameter thereof is measured from the median diameter thus obtained. The measurement sample to be used for this is obtained by weighing 100 mg of the nonmagnetic inorganic filler and 10 g of methyl ethyl ketone into a vial bottle, followed by dispersing this mixture for 10 minutes by means of an ultrasonic wave. The particle diameter distribution of the measurement sample of the nonmagnetic inorganic filler on the volume basis was measured with a flow cell method using the light source wavelengths of blue and red lights by means of the laser diffraction type particle diameter distribution measurement apparatus; then, the average particle diameter thereof was calculated as the median diameter from the particle diameter distribution thus obtained. Illustrative examples of the laser diffraction type particle diameter distribution measurement apparatus include "LA-960" manufactured by Horiba Ltd.

From a viewpoint to enhance the humidity resistance and the dispersion property, the surface of (D) the nonmagnetic filler is preferably treated with one or more surface modifying agents selected from an aminosilane type coupling agent, an epoxysilane type coupling agent, a mercaptosilane type coupling agent, an alkoxysilane type coupling agent, an organosilazane compound, a titanate type coupling agent, and the like. Illustrated examples of the commercially available product of the surface modifying agent include "KBM403" (3-glycidoxypropyltrimethoxysilane) manufactured by Shin-Etsu Chemical Co., Ltd., "KBM803" (3-mercaptopropyltrimethoxysilane) manufactured by Shin-Etsu Chemical Co., Ltd., "KBE903" (3-aminopropyltriethoxysilane) manufactured by Shin-Etsu Chemical Co., Ltd., "KBM573" (N-phenyl-3-aminopropyltrimethoxysilane) manufactured by Shin-Etsu Chemical Co., Ltd., "SZ-31" (hexamethyldisilazane) manufactured by Shin-Etsu Chemical Co., Ltd., "KBM103" (phenyltrimethoxysilane) manufactured by Shin-Etsu Chemical Co., Ltd., "KBM-4803" (a long chain epoxy type silane coupling agent) manufactured by Shin-Etsu Chemical Co., Ltd., and "KBM-7103" (3,3,3-trifluoropropyltrimethoxysilane) manufactured by Shin-Etsu Chemical Co., Ltd.

From a viewpoint to enhance a dispersion property of the nonmagnetic inorganic filler, the degree of the surface modification by means of the surface modifying agent is preferably within a prescribed range. Specifically, the nonmagnetic inorganic filler is surface-modified with a surface modifying agent preferably in the range of 0.2 to 5% by mass, and more preferably in the range of 0.2 to 3% by mass, while still more preferably in the range of 0.3 to 2% by mass, relative to 100% by mass of the nonmagnetic inorganic filler.

The degree of the surface modification by the surface modifying agent may be evaluated by the carbon amount per unit surface area of the nonmagnetic inorganic filler. In view of enhancement of the dispersion property of the nonmagnetic inorganic filler, the carbon amount per unit surface area of the nonmagnetic inorganic filler is preferably 0.02 $mg/m^2$ or more, and more preferably 0.1 $mg/m^2$ or more, while still more preferably 0.2 $mg/m^2$ or more. On the other hand, in view of prevention of the increase in the melt viscosity of the magnetic paste and in the melt viscosity in the sheet form thereof, the carbon amount is preferably 1 $mg/m^2$ or less, and more preferably 0.8 $mg/m^2$ or less, while still more preferably 0.5 $mg/m^2$ or less.

The carbon amount per unit surface area of (D) the nonmagnetic inorganic filler may be measured after the nonmagnetic inorganic filler whose surface has been modified is cleaned by a solvent (for example, methyl ethyl ketone (MEK)). Specifically, after a sufficient amount of MEK as the solvent is added to the nonmagnetic inorganic filler whose surface has been modified with a surface modifying agent, this is cleaned by means of an ultrasonic wave at 25°C for 5 minutes. The supernatant solution thereof is removed; and then, after the remaining solid component is dried, the carbon amount per unit surface area of the nonmagnetic inorganic filler may be measured by using a carbon analysis apparatus. The carbon analysis apparatus such as "EMIA-320V" manufactured by Horiba Ltd., and the like may be used.

From a viewpoint to further enhance the effect of the present invention, the specific surface area of (D) the nonmagnetic inorganic filler is preferably 1 $m^2/g$ or more, and more preferably 2 $m^2/g$ or more, while especially preferably 3 $m^2/g$ or more. Although the upper limit value thereof is not particularly restricted, the value is preferably 50 $m^2/g$ or less, more preferably 20 $m^2/g$ or less, 10 $m^2/g$ or less, or 5 $m^2/g$ or less. The specific surface area of the nonmagnetic inorganic filler may be calculated by means of a BET multipoint method, in which a nitrogen gas is adsorbed onto the sample surface in accordance with a BET method by using a specific surface area measurement apparatus (Macsorb HM-1210, manufactured by Mountech Co. Ltd.).

The content of (D) the nonmagnetic inorganic filler is preferably 10% or less by mass, more preferably 5% or less by mass, and still more preferably 2% or less by mass, while especially preferably 1% or less by mass, on the basis of 100% by mass of the nonvolatile components in the resin composition. When the resin composition includes (D) the nonmagnetic inorganic filler, the lower limit value of the content thereof is not particularly restricted; the value can be, for example, 0.001% or more by mass, 0.01% or more by mass, 0.1% or more by mass, 0.2% or more by mass, or the like.

(E) Other Additives

The resin composition according to the present invention may further include (E) other additives as needed. Illustrative examples of the other additives include: resin additives such as other resin components, a dispersant, a curing retardant such as triethyl borate, a flame retardant, a thickener, an antifoaming agent, a leveling material, an adhesion assisting agent, and a colorant, as well as an organic solvent. The content of the other additives may be determined as appropriate by a person ordinary skilled in the art.

Characteristics of the Resin Composition

The resin composition according to the present invention uses the magnetic powder containing nickel as the magnetic powder. Therefore, when the magnetic cured product of this resin composition is used in the production of the circuit substrate, generation of the magnetic foreign matters that are producible in the treatment liquid at the wet plating process in the substrate production can be suppressed even when the surface of the magnetic cured product layer is not treated with an oxidizing agent.

The mass reduction per the unit surface area when the magnetic cured product that is obtained by thermally curing the resin composition according to the present invention is soaked in a soft etching liquid ($Na_2S_2O_8$ 100 g/L, $H_2SO_4$ (75% aqueous solution)) at 30°C for 1 minute, namely, the etching rate, is preferably 25 $mg/cm^2$ or less, more preferably 20 $mg/cm^2$ or less, and still more preferably 15 $mg/cm^2$ or less, while especially preferably 12 $mg/cm^2$ or less. The lower limit value thereof is not particularly restricted; the value can be, for example, 0.01 $mg/cm^2$ or more, 0.1 $mg/cm^2$ or more, 1 $mg/cm^2$ or more, or the like.

The relative permeability ($\mu'$) of the magnetic cured product that is obtained by thermally curing the resin composition according to the present invention, measured with the measurement frequency of 100 MHz at room temperature (23°C), is preferably 2 or more, more preferably 3 or more, and still more preferably 3.5 or more, while especially preferably 4 or more.

In one embodiment, because the resin composition according to the present invention includes the component (A), the magnetic cured product having the hardness suitable for polishing can be readily obtained. Therefore, in this embodiment, because the magnetic cured product of the resin composition according to the present invention has an excellent polishing property, the polishing at the polishing step (2) at the wet plating process can be readily carried out. Because the resin composition according to the present invention includes the component (A), for example, the pencil hardness of the surface of the magnetic cured product that is obtained by thermally curing the resin composition, measured by the method in accordance with JIS K 5600-5-4, can be preferably 5H or lower, while especially preferably 4H or lower. The lower limit thereof can be preferably F or higher, more preferably H or higher, and still more preferably 2H or higher, while especially preferably 3H or higher.

Production Method of the Resin Composition

The resin composition may be produced, for example, by stirring the blended components with a stirring machine such as a three rolls mixer, a rotation mixer, or a highspeed rotation mixer. The resin composition may be defoamed after the preparation thereof or the like. Illustrative examples of the defoaming method include static defoaming, centrifugal defoaming, vacuum defaming, stirring defoaming, and a combination of them.

At the time of forming the magnetic cured product of the substrate, the resin composition may be used as the form of the paste-like resin composition (magnetic paste) or as the form of the magnetic sheet including the layer of this resin composition.

Examples

Hereinafter, the present invention will be specifically described by Examples, but the present invention is not limited to these Examples. Note that "part" and "%" with regard to the quantity means "part by mass" and "% by mass", respectively, unless otherwise specifically mentioned.

Example 1

A paste-like resin composition was prepared by mixing 8.3 parts by mass of the epoxy resin ("ZX-1059": a mixture of the bisphenol A type epoxy resin and the bisphenol F type epoxy resin, manufactured by Nippon Steel Chemical & Materials Co., Ltd.), 1 part by mass of the curing agent ("2MZA-PW": an imidazole type curing facilitator, 2,4-diamino-6-[2'-methylimidazolyl-(1') ]-ethyl-s-triazine, manufactured by Shikoku Chemicals Corp.), 0.2 part by mass of the fumed silica ("RY200" manufactured by Nippon Aerosil Co., Ltd.), and 62 parts by mass of the magnetic powder ("MA-RCO-S": a Fe-Ni type alloy with 50% Ni content and 50% Fe content, the average particle diameter of 3 um, manufactured by DOWA Electronics Materials Co., Ltd.).

Example 2

A paste-like resin composition was prepared with the same way as Example 1 except that 62 parts by mass of the magnetic powder ("MA-RCO-5": a Fe-Ni type alloy with 50% Ni content and 50% Fe content, the average particle diameter of 3 um, manufactured by DOWA Electronics Materials Co., Ltd.) in Example 1 was changed to 53 parts by mass.

Example 3

A paste-like resin composition was prepared with the same way as Example 1 except that 62 parts by mass of the magnetic powder ("MA-RCO-5": a Fe-Ni type alloy with 50% Ni content and 50% Fe content, the average particle diameter of 3 um, manufactured by DOWA Electronics Materials Co., Ltd.) in Example 1 was changed to 70 parts by mass.

Example 4

A paste-like resin composition was prepared with the same way as Example 1 except that 62 parts by mass of the magnetic powder ("MA-RCO-5": a Fe-Ni type alloy with 50% Ni content and 50% Fe content, the average particle diameter of 3 um, manufactured by DOWA Electronics Materials Co., Ltd.) in Example 1 was changed to 62 parts by mass of the magnetic powder ("80%Ni-4Mo": a Fe-Ni-Mo type alloy with 80% Ni content, 16% Fe content, and 4% Mo content, the average particle diameter of 3 um, manufactured by Epson Atmix Corp.).

Example 5

A paste-like resin composition was prepared with the same way as Example 1 except that 62 parts by mass of the magnetic powder ("MA-RCO-5": a Fe-Ni type alloy with 50% Ni content and 50% Fe content, the average particle diameter of 3 um, manufactured by DOWA Electronics Materials Co., Ltd.) in Example 1 was changed to 44 parts by mass.

Example 6

A paste-like resin composition was prepared with the same way as Example 1 except that 62 parts by mass of the magnetic powder ("MA-RCO-5": a Fe-Ni type alloy with 50% Ni content and 50% Fe content, the average particle diameter of 3 um, manufactured by DOWA Electronics Materials Co., Ltd.) in Example 1 was changed to 36 parts by mass.

Comparative Example 1

A paste-like resin composition was prepared with the same way as Example 1 except that 62 parts by mass of the magnetic powder ("MA-RCO-5": a Fe-Ni type alloy with 50% Ni content and 50% Fe content, the average particle diameter of 3 um, manufactured by DOWA Electronics Materials Co., Ltd.) in Example 1 was changed to 53 parts by mass of the magnetic powder ("AW2-08PF3F": a Fe-Si type alloy with the average particle diameter of 3 um, manufactured by Epson Atmix Corp.).

Comparative Example 2

A paste-like resin composition was prepared with the same way as Example 1 except that 62 parts by mass of the magnetic powder ("MA-RCO-5": a Fe-Ni type alloy with 50% Ni content and 50% Fe content, the average particle diameter of 3 um, manufactured by DOWA Electronics Materials Co., Ltd.) in Example 1 was changed to 62 parts by mass of the magnetic powder ("Fe-6.5Si-4.5Cr": a Fe-Si-Cr type alloy with the average particle diameter of 3 um, manufactured by Epson Atmix Corp.).

Test Example 1: Solubility Evaluation of Magnetic Powder

As the raw material of the paste-like resin composition, 10 g of the magnetic powder was weighed and soaked in 100 mL of 2 N sulfuric acid at 40°C for 5 minutes. Then, the magnetic powder was recovered by using a filter paper (No. 5B, 60 mm$\phi$; manufactured by Kiriyama Glass Co.). After this was dried at 100°C for 60 minutes, the weight of the magnetic powder was measured by using a precision balance to calculate the weight retention rate (%).

Test Example 2: Evaluation of Relative Permeability

A polyethylene terephthalate (PET) film that was treated with a silicone type releasing agent ("PET 501010"; thickness of 50 um; manufactured by Lintec Corp.) was prepared as the support. Each of the paste-like resin compositions in Examples and Comparative Examples was uniformly applied onto the release-treated surface of the PET film by using a doctor blade in such a way that the thickness of the paste layer after dried becomes 100 $\mu$m to obtain a resin sheet. The resin sheet thus obtained was heated at 180°C for 90 minutes to thermally cure the paste layer; then, the support was removed to obtain a sheet-like cured product.
The sheet-like cured product thus prepared was cut to a specimen having the width of 5 mm and the length of 18 mm; this was used as a sample for evaluation. The relative permeability ($\mu$') of the sample for evaluation thus obtained was measured at room temperature (23°C) with the 3-turn coil method at the measurement frequency of 100 MHz by using Agilent Technologies ("HP8362B"; manufactured by Agilent Technologies, Inc.).

Test Example 3: Evaluation of Etching Rate

The sheet-like cured product of Test Example 2 prepared by using each of the paste-like resin compositions in Examples and Comparative Examples was cut to the size of 5 cm x 5 cm and dried at 130°C for 15 minutes; then, the mass thereof immediately after drying was weighed. This was used as the sample A. The mass of the sample A is designated as "X1". The sample A was soaked in the cleaner "Securiganth 902" manufactured by Atotech Japan Co., Ltd. at 60°C for 5 minutes; after cleaned with water, this was soaked in the soft etching liquid ($Na_2S_2O_8$ 100 g/L, $H_2SO_4$ (75% aqueous solution) 14.2 mL/L) at 30°C for 1 minute to obtain the roughened sample A. The roughened sample A was cleaned with water; the mass thereof immediately after drying at 130°C for 15 minutes was measured. The mass of the roughened sample A immediately after drying is designated as "X2". The etching rate (mg/cm$^2$) of the cured product of the resin composition by the roughening treatment was obtained from the following equation.

$$\text{Etching Rate } (mg/cm^2) = \{(X1-X2)/25\}$$

Test Example 4: Evaluation with Pencil Hardness

In the sheet-like cured product of Test Example 2 prepared by using each of the paste-like resin compositions in Examples and Comparative Examples, the hardness of the surface not facing against the PET film in the sheet-like cured product was measured by the test method in accordance with JIS K 5600-5-4. The hardness of the hardest pencil not forming a scar trace was taken as the pencil hardness.

Test Example 5: Evaluation of Amount of Insoluble Matters

Both copper surfaces of the glass cloth substrate epoxy resin copper clad laminate ("R1515A": copper foil thickness of 18 $\mu$m and substrate thickness of 0.8 mm, manufactured by Matsushita Electric Works Co., Ltd.) were roughened by 1 um of etching with a micro-etching agent ("CZ8100", manufactured by MEC Co., Ltd.) to prepare the printing substrate. Onto the printing substrate thus prepared was uniformly applied the prepared resin composition by means of a doctor blade to form a paste layer having the thickness of approximately 120 $\mu$m. The paste layer was thermally cured by heating at 130°C for 30 minutes and further at 145°C for 30 minutes to form the magnetic cured product. The surface of the magnetic cured product thus formed was buff-polished; then, this was cleaned with high-pressure water (3.0 MPa for 15 seconds), and then, heated at 180°C for 30 minutes to conduct the heat treatment. The substrate thereby prepared was cut to the size of the 5-cm square; then, this was used as the substrate for evaluation.
The substrate for evaluation (5-cm square) thereby obtained was soaked in the reducing liquid (60 mL of "Reducer Accelerator 810 mod." (manufactured by Atotech Japan Co., Ltd.) and 3 mL of "Reducer Neoganth WA" (manufactured by Atotech Japan Co., Ltd.)) at 40°C for 24 hours. The deposit thereby precipitated was collected as the insoluble matters by using a filter paper (No. 5B, 60 mm$\phi$; manufactured by Kiriyama Glass Co.). After vacuum drying for 5 hours, the amount of the insoluble matters (mg/L) was measured by using a precision balance. The evaluation was conducted with the standard described as follows:

O: insoluble matters are less than 300 mg/L;
X: insoluble matters are 300 mg/L or more.

Nonvolatile components and the contents thereof in the resin compositions in Examples and Comparative Examples, as well as measurement results and the evaluation results in Test Examples are summarized in the below Table 1.

Table 1

| | | | Ni | Examples | | | | | | Comparative Examples | |
|---|---|---|---|---|---|---|---|---|---|---|---|
| | | | | 1 | 2 | 3 | 4 | 5 | 6 | 1 | 2 |
| Nonvolatile Components (Part by Mass) | Component (A) | MA-RCO-5 | 50wt% | 62 | 53 | 70 | | 44 | 36 | | |
| | | 80%Ni-4Mo | 80wt% | | | | 62 | | | | |
| | | AW2-08 PF3F | 0wt% | | | | | | | 53 | |
| | | Fe-6.5Si-4.5Cr | 0wt% | | | | | | | | 62 |
| | Component (B) | ZX1059 | | 8.33 | 8.33 | 8.33 | 8.33 | 8.33 | 8.33 | 8.33 | 8.33 |
| | Component (C) | 2MZA-PW | | 0.47 | 0.47 | 0.47 | 0.47 | 0.47 | 0.47 | 0.47 | 0.47 |
| | Component (D) | RY200 | | 0.2 | 0.2 | 0.2 | 0.2 | 0.2 | 0.2 | 0.2 | 0.2 |
| | Total of Nonvolatile Components | | | 71 | 62 | 79 | 71 | 53 | 45 | 62 | 71 |
| Content of Component (A) (wt%) | | | | 87.3 | 85.5 | 88.6 | 87.3 | 83.0 | 80.0 | 85.5 | 87.3 |
| Test Results | Weight Retention Rate of Component (A) (%) | | | 96 | 96 | 96 | 97 | 96 | 96 | 6 | 15 |
| | Relative Permeability ($\mu'$) | | | 7.1 | 6.9 | 7.2 | 7.7 | 5.1 | 4.5 | 6.5 | 6.6 |
| | Etching Rate (mg/cm$^2$) | | | 9.9 | 9.5 | 10.1 | 9.5 | 8.9 | 8.5 | 19.3 | 18.3 |
| | Pencil Hardness | | | 4H | 4H | 4H | 4H | 4H | 3H | 6H | 6H |
| | Amount of Insoluble Matters (mg/L) | | | 103 | 84 | 114 | 96 | 84 | 77 | 406 | 439 |
| | | | | O | O | O | O | O | O | × | × |

From Examples, it was found that when the magnetic powder containing nickel was used, generation of the insoluble matters could be significantly suppressed. On the other hand, in Comparative Examples not using the magnetic powder containing nickel, significant amounts of the insoluble matters were precipitated. From Examples, it was also found that in the case where the magnetic powder containing nickel was used, the pencil hardness was lower than and the polishing property was superior to the case where the magnetic powder containing nickel was not used.

Reference Signs List

| | |
|---|---|
| 10 | Core substrate |
| 11 | Supporting substrate |
| 12 | First metal layer |
| 13 | Second metal layer |
| 14 | Trough hole |
| 20 | Plated layer |
| 30a | Resin composition |
| 30 | Magnetic cured product |
| 40 | Conductive layer |
| 41 | Patterned conductive layer |
| 100 | Inductor part |
| 200 | Inner layer substrate |
| 200a | First main surface |
| 200b | Second main surface |
| 220 | Through hole |
| 220a | Inside-the-through-hole wiring |
| 240 | Outside terminal |
| 300 | Magnetic member |
| 310 | Magnetic sheet |
| 320a | Resin composition |
| 320 | First magnetic cured product layer |
| 330 | Support |
| 340 | Second magnetic cured product layer |
| 360 | Via hole |
| 360a | Inside-the-via-hole wiring |
| 400 | Coil-like conductive structural body |
| 420 | First conductive layer |
| 420a | Land |
| 440 | Second conductive layer |

## Claims

1.   A method for producing a circuit substrate, the method comprising:

(1) a step at which a resin composition (30a, 320a) is thermally cured to obtain a magnetic cured product (30, 320, 340),
(2) a step at which at least part of a surface of the magnetic cured product (30, 320, 340) is polished, and
(3) a step at which a conductive layer (40, 420, 440) is formed by wet plating on at least part of the surface of the magnetic cured product thus polished, the steps being included in this order,

the resin composition comprising:

(A) a magnetic powder containing nickel,
(B) an epoxy resin, and
(C) a curing agent,

**characterised in that** a nickel content in the component (A) is in a range of 30 to 90% by mass and

the component (A) comprises at least one selected from a group consisting of nickel-containing iron oxide powders and nickel iron alloy type metal powders.

2. The method for producing a circuit substrate according to claim 1, wherein the component (A) is a nickel iron alloy type metal powder.

3. The method for producing a circuit substrate according to claim 1 or 2, wherein an iron content in the component (A) is in a range of 10 to 70% by mass.

4. The method for producing a circuit substrate according to any one of claims 1 to 3, wherein a content of the component (A) in the resin composition is in a range of 70 to 98% by mass based on 100% by mass of nonvolatile components in the resin composition.

5. The method for producing a circuit substrate according to any one of claims 1 to 4, wherein the component (B) comprises an epoxy resin that is liquid at 25°C.

6. The method for producing a circuit substrate according to any one of claims 1 to 5, wherein the component (C) is a curing agent selected from the group consisting of an acid anhydride type curing agent, an amine type curing agent, and an imidazole type curing agent.

7. The method for producing a circuit substrate according to any one of claims 1 to 6, wherein the resin composition is in a paste-like form.


**Patentansprüche**

1. Verfahren zur Herstellung eines Schaltungsträgers, wobei das Verfahren Folgendes umfasst:

   (1) einen Schritt, bei dem eine Harzzusammensetzung (30a, 320a) heißgehärtet wird, um ein magnetisches gehärtetes Produkt (30, 320, 340) zu erhalten,
   (2) einen Schritt, bei dem zumindest eine Teil einer Oberfläche des magnetischen gehärteten Produkts (30, 320, 340) poliert wird, und
   (3) einen Schritt, bei dem eine leitende Schicht (40, 420, 440) durch Nassplattieren auf zumindest einem Teil der so polierten Oberfläche des magnetischen gehärteten Produkts ausgebildet wird, wobei die Schritte in dieser Reihenfolge enthalten sind,

   wobei die Harzzusammensetzung Folgendes umfasst:

   (A) ein Nickel enthaltendes magnetisches Pulver,
   (B) ein Epoxidharz und
   (C) einen Härter,

   **dadurch gekennzeichnet, dass** der Nickelgehalt in der Komponente (A) im Bereich von 30 bis 90 Massen-% liegt und
   die Komponente (A) zumindest eines, ausgewählt aus der aus nickelhältigen Eisenoxidpulvern und Metallpulvern vom Nickel-Eisen-Legierungstyp bestehenden Gruppe umfasst.

2. Verfahren zur Herstellung eines Schaltungsträgers nach Anspruch 1, wobei die Komponente (A) ein Metallpulver vom Nickel-Eisen-Legierungstyp ist.

3. Verfahren zur Herstellung eines Schaltungsträgers nach Anspruch 1 oder 2, wobei der Eisengehalt in der Komponente (A) im Bereich von 10 bis 70 Massen-% liegt.

4. Verfahren zur Herstellung eines Schaltungsträgers nach einem der Ansprüche 1 bis 3, wobei der Gehalt der Komponente (A) in der Harzzusammensetzung im Bereich von 70 bis 98 Massen-%, bezogen auf 100 Massen-% nichtflüchtiger Komponenten in der Harzzusammensetzung liegt.

5. Verfahren zur Herstellung eines Schaltungsträgers nach einem der Ansprüche 1 bis 4, wobei die Komponente (B) ein Epoxidharz umfasst, das bei 25 °C flüssig ist.

**6.** Verfahren zur Herstellung eines Schaltungsträgers nach einem der Ansprüche 1 bis 5, wobei die Komponente (C) ein Härter ist, der aus der aus einem Härter vom Säureanhydrid-Typ, einem Härter vom Amin-Typ und einem Härter vom Imidazol-Typ bestehenden Gruppe ausgewählt ist.

**7.** Verfahren zur Herstellung eines Schaltungsträgers nach einem der Ansprüche 1 bis 6, wobei die Harzzusammensetzung in pastöser Form vorliegt.

**Revendications**

**1.** Procédé de production d'un substrat de circuit, le procédé comprenant :

(1) une étape au cours de laquelle une composition de résine (30a, 320a) est durcie thermiquement pour obtenir un produit durci magnétique (30, 320, 340),
(2) une étape au cours de laquelle au moins une partie d'une surface du produit durci magnétique (30, 320, 340) est polie, et
(3) une étape au cours de laquelle une couche conductrice (40, 420, 440) est formée par placage humide sur au moins une partie de la surface du produit durci magnétique ainsi poli, les étapes étant incluses dans cet ordre, la composition de résine comprenant :

(A) une poudre magnétique contenant du nickel,
(B) une résine époxy, et
(C) un agent de durcissement,
**caractérisée en ce que** la teneur en nickel dans le composant (A) est dans une plage allant de 30 à 90 % en masse, et
le composant (A) comprend au moins sélectionné dans un groupe constitué de poudres d'oxyde de fer contenant du nickel et de poudres métalliques de type alliage de fer et de nickel.

**2.** Procédé de production d'un substrat de circuit selon la revendication 1, dans lequel le composant (A) est une poudre métallique de type alliage de nickel et de fer.

**3.** Procédé de production d'un substrat de circuit selon la revendication 1 ou 2, dans lequel une teneur en fer dans le composant (A) est dans une plage allant de 10 à 70 % en masse.

**4.** Procédé de production d'un substrat de circuit selon l'une quelconque des revendications 1 à 3, dans lequel une teneur du composant (A) dans la composition de résine est dans une plage allant de 70 à 98 % en masse sur la base de 100 % en masse de composants non volatils dans la composition de résine.

**5.** Procédé de production d'un substrat de circuit selon l'une quelconque des revendications 1 à 4, dans lequel le composant (B) comprend une résine époxy qui est liquide à 25°C.

**6.** Procédé de production d'un substrat de circuit selon l'une quelconque des revendications 1 à 5, dans lequel le composant (C) est un agent de durcissement choisi dans le groupe constitué d'un agent de durcissement de type anhydride d'acide, d'un agent de durcissement de type amine et d'un agent de durcissement de type imidazole.

**7.** Procédé de production d'un substrat de circuit selon l'une quelconque des revendications 1 à 6, dans lequel la composition de résine est sous forme de pâte.

[FIG. 1]

[FIG. 2]

[FIG. 3]

[FIG. 4]

[FIG. 5]

[FIG. 6]

[FIG. 7]

[FIG. 8]

[FIG. 9]

[FIG. 10]

420           420

330
310
320
200

240 220a 220 420    200a  200b  420    240 220a 220

[FIG. 11]

420           420

320
200

240 220a 220 420 360   200a  200b  420 360 240 220a 220

[FIG. 12]

[FIG. 13]

[FIG. 14]

[FIG. 15]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2002033275 A
- JP 2009016504 A
- JP 2012186440 A
- JP 2016197624 A